# EUROPÄISCHE PATENTSCHRIFT

(11) **EP 2 569 100 B1**
(45) Veröffentlichungstag und Bekanntmachung des Hinweises auf die Patenterteilung: **20.01.2016**
(21) Anmeldenummer: 11718985.2
(22) Anmeldetag: 05.05.2011
(51) Int. Cl.: B08B 1/04, B08B 3/02, B08B 3/04, B08B 3/08, B08B 3/10, B08B 3/12, B08B 5/04, B08B 7/04

(54) **PROZESSBEHÄLTER**
PROCESSING CONTAINER
CONTENEUR DE TRAITEMENT

(30) Priorität: 11.05.2010 DE 102010028883
(43) Veröffentlichungstag der Anmeldung: 20.03.2013
(73) Patentinhaber: Dürr Ecoclean GmbH, 70794 Filderstadt (DE)
(72) Erfinder: DAVID, Hermann-Josef, 52156 Monschau (DE); KÄSKE, Egon, 52078 Aachen (DE)
(74) Vertreter: Hoeger, Stellrecht & Partner Patentanwälte mbB
(86) Internationale Anmeldenummer: PCT/EP2011/057226
(87) Internationale Veröffentlichungsnummer: WO 2011/141351

(56) Entgegenhaltungen:
- DE-A1- 2 049 599
- DE-A1- 4 220 827
- DE-A1-102008 049 378
- DE-U1- 9 115 546
- DE-U1-202006 013 351
- US-A- 5 279 316
- US-B1- 6 235 147

## Beschreibung

Die vorliegende Erfindung betrifft einen Prozessbehälter zum Durchführen eines Reinigungsvorgangs, eines Trocknungsvorgangs, eines Entgratungsvorgangs, eines Beschichtungsvorgangs und/oder eines Entschichtungsvorgangs an einem Werkstück im Innenraum des Prozessbehälters, wobei der Prozessbehälter eine den Innenraum des Prozessbehälters begrenzende Wandung umfasst.

Solche Prozessbehälter sind insbesondere für die Durchführung eines Flutwaschvorgangs oder eines Spritzreinigungsvorgangs bekannt.

Die bekannten Prozessbehälter sind nicht wartungsfreundlich aufgebaut und jeweils speziell für die Durchführung eines einzigen Behandlungsvorgangs oder einer einzigen Abfolge von Behandlungsvorgängen ausgebildet.

Die DE 42 20 827 A1 offenbart einen Prozessbehälter gemäß dem Oberbegriff von Anspruch 1.

Die DE 20 49 599 A1 offenbart einen Prozessbehälter mit einem Oberteil und einem Unterteil, wobei das Oberteil und das Unterteil eine gemeinsame, durchgehende Gehäusewand aufweisen und auf einem Wagen angeordnete Werkstücke durch eine seitlich an dem Oberteil angeordnete Seitentür in den Innenraum des Prozessbehälters eingefahren werden.

Der vorliegenden Erfindung liegt die Aufgabe zugrunde, einen Prozessbehälter der vorstehend genannten Art zu schaffen, welcher wartungsfreundlich und flexibel einsetzbar ist.

Diese Aufgabe wird durch einen Prozessbehälter nach Anspruch 1 gelöst.

Der Begriff "Medium" umfasst dabei im Rahmen dieser Beschreibung und der beigefügten Ansprüche sowohl Materie in fester, flüssiger oder gasförmiger Form als auch Energie oder Information.

Bei dem durch die Wandung des Prozessbehälters hindurchführbaren Medium kann es sich also beispielsweise um fluide Materie handeln, insbesondere um ein Reinigungsmedium mit oder ohne Verunreinigungen, welches durch die betreffende Medium-Durchführung von einem Außenraum des Prozessbehälters in dessen Innenraum oder von dem Innenraum in den Außenraum des Prozessbehälters transportierbar ist.

Bei dem Medium kann es sich aber auch um Energie, insbesondere elektrische Energie, handeln, welche durch die jeweilige Medium-Durchführung in den Prozessbehälter eingebracht wird.

Ferner kann es sich bei dem Medium um Information, beispielsweise in Form von Messdaten oder Steuersignalen, handeln, welche über eine entsprechende Daten- oder Signalleitung von dem Außenraum des Prozessbehälters in dessen Innenraum oder von dem Innenraum in den Außenraum des Prozessbehälters transportierbar ist.

Unter einem "Prozesselement" ist grundsätzlich jedes Element zu verstehen, das bei einem in dem Prozessbehälter ablaufenden Behandlungsvorgang (Prozess) verwendet wird.

Insbesondere kann es sich bei einem Prozesselement um eine Behandlungseinheit, um einen Verschlussdeckel, um eine Werkzeughalterung oder um eine Werkstückhalterung oder Werkstückauflage handeln.

Durch das einfache Adaptieren (Anschließen) von Prozesselementen unterschiedlichen Typs an mindestens eine der Medium-Durchführungen des Prozessbehälters kann der Prozessbehälter einfach und rasch für die Durchführung unterschiedlicher Behandlungsvorgänge konfiguriert werden.

Ein und derselbe Prozessbehälter kann daher für unterschiedlichste Behandlungsvorgänge verwendet und somit besonders flexibel genutzt werden.

Durch Adaptierung jeweils geeigneter Prozesselemente kann der erfindungsgemäße Prozessbehälter insbesondere für die Durchführung von einem oder mehreren der folgenden Vorgänge genutzt werden:
- für einen Spritzreinigungsvorgang;
- für einen Tauchreinigungsvorgang;
- für einen Injektionsflutwasch-Reinigungsvorgang (bei einem solchen Injektionsflutwasch-Reinigungsvorgang ist der Prozessbehälter zumindest teilweise mit einem Bad einer Reinigungsflüssigkeit gefüllt, in welches das zu reinigende Werkstück zumindest teilweise eingetaucht wird, und ein Düsensystem erzeugt eine turbulente Strömung oder eine pulsierende turbulente Strömung in dem Reinigungsflüssigkeits-Bad im Prozessbehälter);
- für einen Ultraschallreinigungsvorgang;
- für einen Hochdruckentgratungsvorgang;
- für einen Bürstentgratungsvorgang;
- für einen Blastrocknungsvorgang;
- für einen Vakuumtrocknungsvorgang; und/oder
- für einen Dampfreinigungsvorgang.

Der erfindungsgemäße Prozessbehälter ist insbesondere in einer Behandlungsvorrichtung verwendbar, welche mehrere solche Prozessbehälter umfasst, die vorzugsweise miteinander identisch aufgebaut sind und vorzugsweise durch die Adaptierung von Prozesselementen unterschiedlichen Typs für die Durchführung unterschiedlicher Behandlungsvorgänge konfiguriert sind.

Eine solche Reinigungsvorrichtung ist somit aus mehreren Prozessbehältern und den jeweils an die Medium-Durchführungen der Prozessbehälter adaptierten Prozesselementen modular aufgebaut.

Der erfindungsgemäße Prozessbehälter kann daher auch als Prozessmodul bezeichnet werden.

Ferner ermöglicht es der erfindungsgemäße Prozessbehälter, Behandlungsvorrichtungen zur Durchführung unterschiedlicher Behandlungsvorgänge in einfacher und Montagezeit sowie Kosten sparender Weise aus jeweils mindestens einem erfindungsgemäßen Prozessbehälter und jeweils mindestens einem an eine Medium-Durchführung mindestens eines Prozessbehälters adaptierten Prozesselement, das für die Durchführung des jeweiligen Behandlungsvorgangs geeignet ist, herzustellen.

Ein an eine Medium-Durchführung eines erfindungsgemäßen Prozessbehälters adaptierbares Prozesselement kann insbesondere ein Düsensystem, eine Hochdruckapplikation, ein Blaselement, ein Vakuumelement oder ein Entgratsystem sein.

Der erfindungsgemäße, multifunktionale Prozessbehälter eignet sich insbesondere zur Durchführung eines Reinigungsvorgangs, eines Trocknungsvorgangs, eines Entgratungsvorgangs, eines Beschichtungsvorgangs und/oder eines Entschichtungsvorgangs.

In den Prozessbehälter ist vorzugsweise mindestens ein totraumfreier Anschluss integriert, über welchen ein für den Behandlungsvorgang erforderliches Verfahrensmedium und/oder die für einen Behandlungsvorgang erforderliche Energie dem Innenraum des Prozessbehälters zugeführt und/oder aus dem Innenraum des Prozessbehälters abgeführt werden kann.

Vorzugsweise ist vorgesehen, dass mindestens eine der Medien-Durchführungen des Prozessbehälters einen totraumfreien Adapter zum Adaptieren eines Prozesselements aufweist.

Der erfindungsgemäße Prozessbehälter ist besonders flexibel konfigurierbar, wenn er mindestens zwei Medium-Durchführungen umfasst, die miteinander identische Adapter aufweisen. In diesem Fall kann ein Prozesselement mit einem hierzu passenden Adapter wahlweise an verschiedene Medium-Durchführungen des Prozessbehälters adaptiert werden.

Um auch komplexere Behandlungsvorgänge mit mehreren Prozesselementen durchführen zu können, ist es günstig, wenn der Prozessbehälter zwei oder mehr Medien-Durchführungen umfasst.

Insbesondere kann vorgesehen sein, dass der Prozessbehälter drei oder mehr, besonders bevorzugt vier oder mehr, Medien-Durchführungen umfasst.

Bei einer bevorzugten Ausgestaltung des Prozessbehälters ist vorgesehen, dass mindestens zwei der Medium-Durchführungen in im Wesentlichen konstanten Winkelabständen bezüglich einer vertikalen Mittelachse des Prozessbehälters angeordnet sind.

Ferner ist bei einer bevorzugten Ausgestaltung der Erfindung vorgesehen, dass eine der Medien-Durchführungen an einer tiefsten Stelle des Innenraums des Prozessbehälters in den Innenraum des Prozessbehälters mündet. Hierdurch kann der Prozessbehälter selbstentleerend ausgebildet sein, da ein im Innenraum des Prozessbehälters befindliches Medium durch eine solche Medien-Durchführung aus dem Innenraum des Prozessbehälters ablaufen kann.

Der Prozessbehälter umfasst ein abnehmbares Behälteroberteil. Nach dem Abnehmen des Behälteroberteils ist es besonders einfach, ein Prozesselement innenraumseitig an eine Medium-Durchführung des Prozessbehälters zu adaptieren, ein solches innenraumseitig adaptiertes Prozesselement zu warten oder zu reparieren oder gegen ein anderes Prozesselement auszutauschen.

Ferner sind nach Abnehmen des Behälteroberteils ein oder mehrere Prozesselemente, die an jeweils eine Medium-Durchführung des Prozessbehälters adaptiert sind, besonders einfach für einen sogenannten "Teaching"-Vorgang zugänglich, bei welchem an einem Handhabungsgerät, welches ein zu behandelndes Werkstück hält, manuell die Bewegungen durchgeführt werden, welche das Handhabungsgerät im normalen Betrieb der Behandlungsvorrichtung automatisch durchführen soll.

Das Behälteroberteil ist vorzugsweise mittels einer totraumfreien Dichtungsanordnung mit einem Behälterunterteil des Prozessbehälters verbunden.

Um einen einfachen und raschen Transport eines zu behandelnden Werkstücks zwischen dem Innenraum und dem Außenraum des Prozessbehälters zu ermöglichen, ist es günstig, dass der Prozessbehälter eine Zugangsöffnung aufweist, durch welche ein an einem Handhabungsgerät gehaltenes Werkstück in den Innenraum des Prozessbehälters einbringbar ist.

Die Zugangsöffnung ist an einer Oberseite des Prozessbehälters angeordnet.

Der Prozessbehälter ist vorzugsweise so gestaltet, dass ein sicherer Austrag von Partikeln und Feststoffen aus dem Innenraum des Prozessbehälters während des Behandlungsvorgangs gewährleistet ist und, im Falle eines Reinigungsvorgangs, keine Rückkontamination des Waschgutes erfolgt.

Die Oberflächen des Prozessbehälters sind vorzugsweise so beschaffen, dass Einlagerungen von Partikeln und Bakterien in den Oberflächen verhindert werden.

Insbesondere kann vorgesehen sein, dass die Oberfläche des Prozessbehälters zumindest an dessen Innenseite selbstreinigend ausgebildet ist.

Zur Vermeidung von Einlagerungen an der Wandung des Prozessbehälters ist es günstig, wenn die Wandung des Prozessbehälters zumindest an deren Innenseite zumindest abschnittsweise eine Oberflächenrauigkeit von weniger als ungefähr 0,8 µm aufweist.

Besonders günstig ist es, wenn die Wandung des Prozessbehälters zumindest an dessen Innenseite im Wesentlichen überall eine Oberflächenrauigkeit von weniger als ungefähr 0,8 µm aufweist.

Durch die leichte Demontierbarkeit des Behälteroberteils und/oder anderer Teile der Wandung des Prozessbehälters ist der erfindungsgemäße Prozessbehälter besonders wartungs- und inspektionsfreundlich aufgebaut.

Um einen unbeabsichtigten Austritt eines Mediums aus dem Innenraum des Prozessbehälters in dessen Außenraum zu verhindern, kann vorgesehen sein, dass mindestens eine der Medium-Durchführungen mittels eines an einen Adapter der Medium-Durchführung adaptierten Verschlussdeckels verschließbar ist.

Vorzugsweise weist ein solcher Verschlussdeckel mindestens eine obere Begrenzungsfläche auf, welche gegen die Horizontale geneigt ist, so dass eine Ablagerung von Medien oder Verschmutzungen an dem Verschlussdeckel vermieden wird.

Vorzugsweise weist mindestens eine Medium-Durchführung des Prozessbehälters einen innenraumseitigen Adapter zum Adaptieren eines Prozesselements auf.

Ferner weist vorzugsweise mindestens eine Medien-Durchführung des Prozessbehälters mindestens einen außenraumseitigen Adapter zum Adaptieren eines Prozesselements auf.

Bei einer bevorzugten Ausgestaltung der Erfindung ist vorgesehen, dass mindestens eine Medien-Durchführung des Prozessbehälters sowohl einen innenraumseitigen Adapter zum Adaptieren eines Prozesselements als auch einen außenraumseitigen Adapter zum Adaptieren eines Prozesselements aufweist.

Um den Prozessbehälter besonders standsicher aufstellen zu können, ist es günstig, wenn der Prozessbehälter ein Aufnahmeelement umfasst, über welches der Prozessbehälter an einer externen Lagerung abstützbar ist.

Ein solches Aufnahmeelement kann insbesondere im Wesentlichen plattenförmig ausgebildet sein.

Ferner ist es günstig, wenn ein solches Aufnahmeelement mindestens eine Durchtrittsöffnung für den Durchtritt einer Medien-Durchführung des Prozessbehälters durch das Aufnahmeelement aufweist.

Ferner kann vorgesehen sein, dass ein solches Aufnahmeelement mindestens eine Durchtrittsöffnung für den Durchtritt eines Mediums durch das Aufnahmeelement zu mindestens einer Medien-Durchführung des Prozessbehälters aufweist.

Um das Aufnahmeelement sicher mit einem Grundkörper des Prozessbehälters zu verbinden, kann vorgesehen sein, dass mindestens eine der Medien-Durchführungen des Prozessbehälters einen außerhalb des Innenraums des Prozessbehälters angeordneten Adapter zum Adaptieren des Aufnahmeelements an die betreffende Medien-Durchführung aufweist.

Bei einer bevorzugten Ausgestaltung des erfindungsgemäßen Prozessbehälters weist mindestens eine der Medien-Durchführungen des Prozessbehälters mindestens eine an einer Außenwand der Medien-Durchführung und im Innenraum des Prozessbehälters angeordnete Halterung zum Haltern einer Behandlungseinheit und/oder einer Werkstückaufnahme auf.

Eine solche Halterung ist vorzugsweise an einer Umfangswand einer vorzugsweise rohrförmig ausgebildeten Medien-Durchführung angeordnet.

Der erfindungsgemäße Prozessbehälter eignet sich insbesondere zur Verwendung in einer Kombination aus mindestens einem erfindungsgemäßen Prozessbehälter und mindestens zwei Prozesselementen unterschiedlichen Typs, die wahlweise an dieselbe Medium-Durchführung des Prozessbehälters adaptierbar sind. Hierdurch kann der Prozessbehälter durch Austausch der Prozesselemente in einfacher Weise für die Durchführung unterschiedlicher Behandlungsvorgänge konfiguriert werden.

Ferner eignet sich der erfindungsgemäße Prozessbehälter insbesondere zur Verwendung in einer Kombination aus mindestens zwei erfindungsgemäßen Prozessbehältern und mindestens einem Prozesselement, das wahlweise an eine Medien-Durchführung eines ersten Prozessbehälters oder an eine Medien-Durchführung eines zweiten Prozessbehälters adaptierbar ist. Auf diese Weise können mehrere erfindungsgemäße Prozessbehälter durch Adaptieren des jeweils erforderlichen Prozesselements wahlweise für die Durchführung eines gewünschten Behandlungsvorgangs konfiguriert werden.

Eine Kombination aus mindestens einem erfindungsgemäßen Prozessbehälter und mindestens einem an eine Medium-Durchführung eines erfindungsgemäßen Prozessbehälters adaptierbaren Prozesselement umfasst ferner vorzugsweise mindestens ein Handhabungsgerät zum Einbringen eines zu behandelnden Werkstücks in den Innenraum mindestens eines der Prozessbehälter.

Eine solche Kombination aus mindestens einem Prozessbehälter, mindestens einem Prozesselement und mindestens einem Handhabungsgerät bildet eine modular aufgebaute Behandlungsvorrichtung.

Eine Kombination aus mindestens einem erfindungsgemäßen Prozessbehälter und mindestens einem an eine Medium-Durchführung eines solches Prozessbehälters adaptierbaren Prozesselement umfasst als Prozesselement vorzugsweise eine Spritzreinigungseinheit, eine Injektions-Flutwascheinheit, eine Ultraschallreinigungseinheit, eine Hochdruckentgratungseinheit, eine Bürstentgratungseinheit, eine Blastrocknungseinheit, eine Dampfreinigungseinheit, eine Absaugeinheit, eine Belüftungseinheit, eine Werkstückaufnahme, eine Werkstückbewegungseinheit und/oder eine Flüssigvorhangerzeugungseinheit.

Ferner kann vorgesehen sein, dass der erfindungsgemäße Prozessbehälter mindestens eine Reflektionsfläche zum Reflektieren von Ultraschallwellen in den Innenraum des Prozessbehälters umfasst.

Für die Durchführung eines Behandlungsvorgangs unter Vakuum ist es günstig, wenn der Prozessbehälter einen vakuumdichten Deckel umfasst.

Ein solcher vakuumdichter Deckel kann insbesondere schwenkbar gelagert sein.

Ferner ist es günstig, wenn der erfindungsgemäße Prozessbehälter ein Leitelement, beispielsweise ein Leitblech, umfasst, welches ein nicht zu einem zu behandelnden Werkstück gelangendes Verfahrensmedium und/oder ein von einem zu behandelnden Werkstück abprallendes Verfahrensmedium (sogenannter Overspray) zumindest teilweise in den Innenraum des Prozessbehälters lenkt.

Das Handhabungsgerät kann insbesondere als ein Roboter ausgebildet sein.

Das Handhabungsgerät weist vorzugsweise eine Greifeinrichtung zum Ergreifen des Werkstücks auf.

Vorzugsweise weist das Handhabungsgerät mindestens drei, besonders bevorzugt mindestens vier, insbesondere mindestens fünf, beispielsweise mindestens sechs, Bewegungsfreiheitsgrade auf.

Das Handhabungsgerät weist vorzugsweise einen "Teaching"-Modus auf, in welchem Bewegungen, welche das Handhabungsgerät im Normalbetrieb des Handhabungsgeräts automatisch ausführen soll, manuell an dem Handhabungsgerät ausgeführt werden und dabei für die spätere Durchführung abgespeichert werden.

Weitere Merkmale und Vorteile der Erfindung sind Gegenstand der nachfolgenden Beschreibung und der zeichnerischen Darstellung von Ausführungsbeispielen.

In den Zeichnungen zeigen:
- Fig. 1: einen schematischen vertikalen Schnitt durch einen Prozessbehälter mit einer mittigen Medium-Durchführung, die an der tiefsten Stelle des Innenraums des Prozessbehälters in den Prozessbehälter mündet, und mit drei weiteren Medium-Durchführungen, die oberhalb der mittigen Medium-Durchführung längs des Umfangs des Prozessbehälters äquidistant verteilt sind (wobei in Fig. 1 nur zwei dieser oberen Medium-Durchführungen zu sehen sind);
- Fig. 2: eine vergrößerte Darstellung des Bereichs I aus Fig. 1, welche einen Verbindungsbereich zwischen einem Unterteil und einem abnehmbaren Oberteil des Prozessbehälters zeigt;
- Fig. 3: eine Draufsicht von oben auf den Prozessbehälter aus Fig. 1 mit der Blickrichtung in Richtung des Pfeils 3 in Fig. 1;
- Fig. 4: einen schematischen vertikalen Schnitt durch den Prozessbehälter, nachdem ein Behälteroberteil abgenommen worden ist;
- Fig. 5: eine Variante des Prozessbehälters auf Fig. 1, welche zusätzlich eine Aufnahmeplatte umfasst, mit welcher der Prozessbehälter sich an einer externen Lagerung abstützt;
- Fig. 6: eine schematische Seitenansicht eines Handhabungsgeräts, welches ein zu behandelndes Werkstück durch eine obere Zugangsöffnung des Prozessbehälters in den Innenraum des Prozessbehälters einbringt;
- Fig. 7: einen schematischen vertikalen Schnitt durch einen Prozessbehälter mit Behandlungseinheiten zum Durchführen eines Injektionsflutwaschens, welches ein kontinuierliches Injektionsflutwaschen (mit ununterbrochener Erzeugung einer turbulenten Strömung mittels Düsen) oder ein pulsierendes Injektionsflutwaschen (mit intermittierender Erzeugung einer turbulenten Strömung mittels Düsen) sein kann;
- Fig. 8: eine vergrößerte Darstellung des Bereichs II aus Fig. 7, welcher die Verbindung zwischen einem innenraumseitigen Adapter einer Medium-Durchführung des Prozessbehälters und einem daran angepassten Adapter einer Behandlungseinheit zeigt;
- Fig. 9: einen schematischen Schnitt durch einen Prozessbehälter mit darin angeordneten Behandlungseinheiten zum Durchführen eines Abblasvorgangs;
- Fig. 10: einen schematischen Schnitt durch einen Prozessbehälter mit darin angeordneten Behandlungseinheiten zum Durchführen einer Ultraschallreinigung;
- Fig. 11: eine vergrößerte Darstellung des Bereichs III aus Fig. 10, welcher eine zweifach genutzte Medium-Durchführung für die Zuführung und für die Abführung eines Reinigungsmediums zeigt;
- Fig. 12: einen schematischen Schnitt durch einen Prozessbehälter mit darin angeordneten Behandlungseinheiten zur Durchführung einer Spritzreinigung;
- Fig. 13: einen schematischen Schnitt durch einen Prozessbehälter mit darin angeordneten Behandlungseinheiten zur Durchführung einer Hochdruckentgratung, wobei mindestens eine Medium-Durchführung innenraumseitig mittels eines Verschlussdeckels verschlossen ist;
- Fig. 14: eine vergrößerte Darstellung des Bereichs IV aus Fig. 13, welcher einen innenraumseitigen Adapter einer Medium-Durchführung und einen damit verbundenen Verschlussdeckel zeigt;
- Fig. 15: einen schematischen Schnitt durch einen Prozessbehälter mit darin angeordneten Behandlungseinheiten zur Durchführung einer Bürstentgratung;
- Fig. 16: einen schematischen Schnitt durch einen Prozessbehälter und eine Hochdruck-Behandlungseinheit mit mehreren HochdruckWerkzeugen, die um eine horizontale Drehachse drehbar und wahlweise in eine Arbeitsposition im Innenraum des Prozessbehälters bringbar sind;
- Fig. 17: einen schematischen Schnitt durch einen Prozessbehälter und eine Hochdruck-Behandlungseinheit mit mehreren HochdruckWerkzeugen, die um eine vertikale Drehachse drehbar und wahlweise in eine Arbeitsposition im Innenraum des Prozessbehälters bringbar sind;
- Fig. 18: einen schematischen Schnitt durch einen Prozessbehälter mit darin angeordneten Behandlungseinheiten zum Durchführen einer Spritzreinigung und mit einer an Halterungen von Medium-Durchführungen gehaltenen Werkstück-Arretiervorrichtung;
- Fig. 19: eine schematische Seitenansicht eines innenraumseitigen Endbereichs einer Medium-Durchführung mit einem innenraumseitigen Adapter, mit dem ein Verschlussdeckel verbunden ist, und mit einer am Außenumfang der Medien-Durchführung angeordneten Halterung zum Haltern einer Behandlungseinheit und/oder einer Werkstückaufnahme;
- Fig. 20: eine schematische Vorderansicht der Halterung der Medium-Durchführung aus Fig. 19, mit der Blickrichtung in Richtung des Pfeils 20 in Fig. 19;
- Fig. 21: einen schematischen Schnitt durch einen Prozessbehälter mit einem vakuumdichten Deckel zum Durchführen einer Vakuumtrocknung;
- Fig. 22: einen schematischen Schnitt durch einen Prozessbehälter mit mehreren im Innenraum des Prozessbehälters angeordneten Werkstückaufnahmen zur gleichzeitigen Behandlung mehrerer Werkstücke und mit einer Behandlungseinheit zur Durchführung eines Injektionsflutwaschens;
- Fig. 23: einen schematischen Schnitt durch einen Prozessbehälter mit einer darin angeordneten Werkstück-Dreheinrichtung und einer Behandlungseinheit zur Durchführung einer Spritzreinigung;
- Fig. 24: einen schematischen Schnitt durch einen Prozessbehälter mit einer darin angeordneten Werkstückhubeinrichtung und einer Behandlungseinheit zur Durchführung einer Ultraschallreinigung;
- Fig. 25: einen schematischen Schnitt durch einen Prozessbehälter mit Behandlungseinheiten zur Durchführung einer Ultraschallreinigung mit gezieltem Absaugen von Verunreinigungen aus einem Reinigungsbad;
- Fig. 26: einen schematischen Schnitt durch einen Prozessbehälter mit einer darin angeordneten Behandlungseinheit zur Durchführung einer Spritzreinigung und mit einem Leitblech zur Vermeidung von Overspray; und
- Fig. 27: einen schematischen Schnitt durch einen Prozessbehälter mit darin angeordneten Behandlungseinheiten zur Durchführung einer Spritzreinigung bei gleichzeitiger Erzeugung eines Wasservorhangs zur Vermeidung von Overspray.

Gleiche oder funktional äquivalente Elemente sind in allen Figuren mit denselben Bezugszeichen bezeichnet.

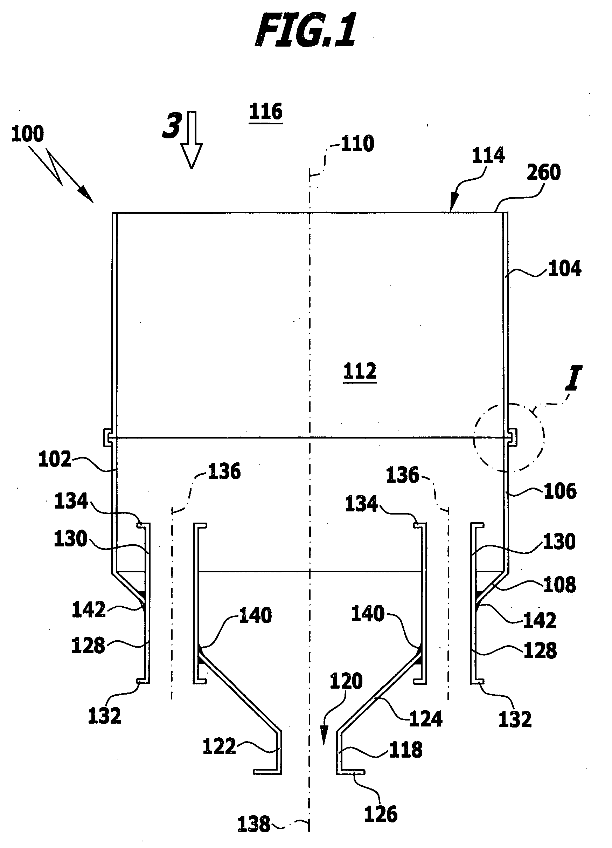

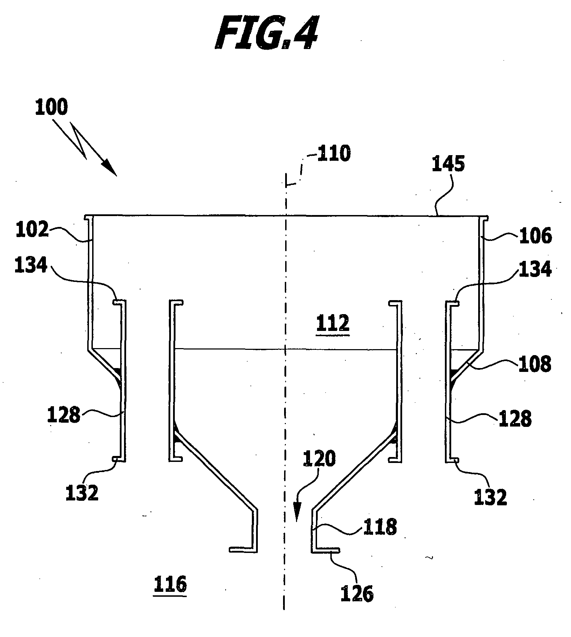

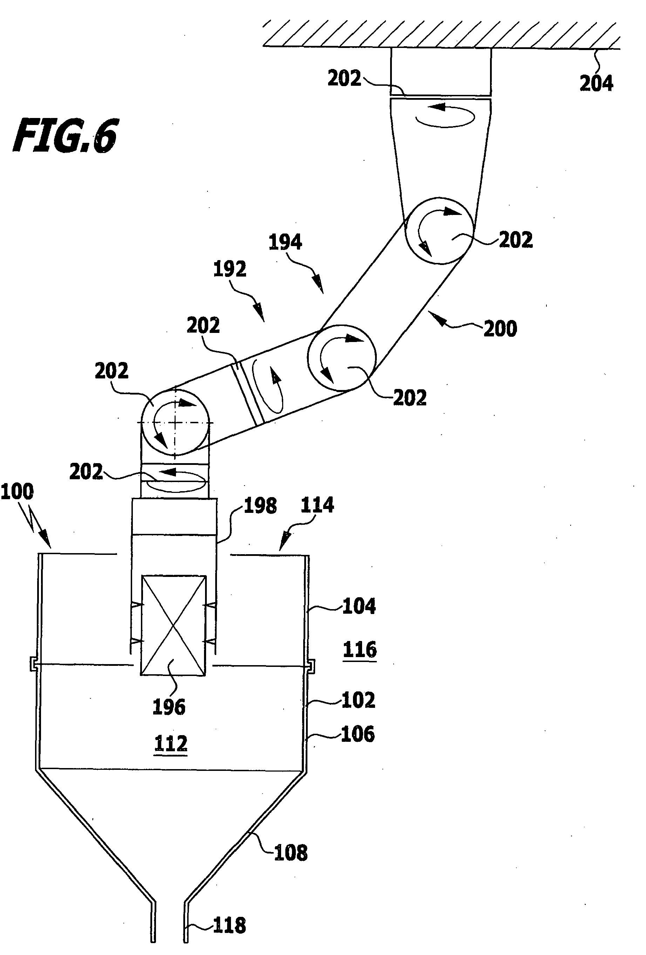

Ein in den Figuren 1 bis 5 separat und in den Figuren 6 bis 27 in verschiedenen Konfigurationen mit Behandlungseinheiten, Werkstückaufnahmen und Handhabungsgeräten dargestellter, als Ganzes mit 100 bezeichneter Prozessbehälter umfasst ein Behälterunterteil 102 und ein auf das Behälterunterteil 102 abnehmbar aufgesetztes Behälteroberteil 104 (siehe insbesondere Fig. 1).

Das Behälterunterteil 102 umfasst einen im Wesentlichen hohlzylindrischen oberen Abschnitt 106 und einen im Wesentlichen kegelstumpfmantelförmigen, sich konisch nach unten verjüngenden unteren Abschnitt 108.

Das Behälterunterteil 102 und das Behälteroberteil 104 sind im Wesentlichen rotationssymmetrisch zu einer mittigen, im Betriebszustand des Prozessbehälters 100 im Wesentlichen vertikal ausgerichteten Mittelachse 110 des Prozessbehälters 100 ausgebildet.

Das Behälterunterteil 102 und das Behälteroberteil 104 umschließen gemeinsam einen Innenraum 112 des Prozessbehälters 100, der über eine Zugangsöffnung 114 am oberen Rand 260 des Behälteroberteils 104 von einem Außenraum 116 des Prozessbehälters 100 aus zugänglich ist.

An der tiefsten Stelle des Innenraums 112 mündet eine untere Medium-Durchführung 118 an einer Mündungsöffnung 120 in den Innenraum 112.

Die untere Medium-Durchführung 118 ist beispielsweise im Wesentlichen rohrförmig ausgebildet und umfasst eine hohlzylindrische Wandung 122, welche an der Mündungsöffnung 120, vorzugsweise nahtlos, in die Wandung 124 des Behälterunterteils 102 übergeht, und einen am unteren Rand der hohlzylindrischen Wandung 122 angeordneten außenraumseitigen Adapter 126 zum Adaptieren (Anschließen) von Prozesselementen, insbesondere Zuführ- oder Abführleitungen.

Ferner umfasst der Prozessbehälter 100 mehrere, beispielsweise drei, obere Medium-Durchführungen 128, welche sich jeweils durch die Wandung 124 des unteren Abschnitts 108 des Behälterunterteils 102 hindurch erstrecken.

Jede der oberen Medium-Durchführungen 128 ist beispielsweise im Wesentlichen rohrförmig ausgebildet und umfasst eine hohlzylindrische Wandung 130, einen am unteren Rand der hohlzylindrischen Wandung 130 angeordneten außenraumseitigen Adapter 132 zum Adaptieren (Anschließen) von Prozesselementen, insbesondere von Zuführ- oder Abführleitungen, oder zum Adaptieren einer Aufnahmeplatte, und einen an einem oberen Rand der hohlzylindrischen Wandung 130 angeordneten innenraumseitigen Adapter 134 zum Adaptieren (Anschließen) von Prozesselementen, insbesondere von Behandlungseinheiten oder eines Verschlussdeckels.

Die Längsmittelachsen 136 der oberen Medium-Durchführungen 128 und die Längsmittelachse 138 der unteren Medium-Durchführung 118, welche vorzugsweise mit der Mittelachse 110 des Prozessbehälters 100 zusammenfällt, sind vorzugsweise im Wesentlichen parallel zueinander und vorzugsweise im Wesentlichen vertikal ausgerichtet.

Das Behälterunterteil 102, das Behälteroberteil 104, die untere Medium-Durchführung 118 und/oder die oberen Medium-Durchführungen 128 des Prozessbehälters 100 sind vorzugsweise aus einem metallischen Material, insbesondere aus einem Stahlmaterial, vorzugsweise aus einem Edelstahlmaterial, gebildet.

Die oberen Medium-Durchführungen 128 sind dort, wo sie die Wandung 124 des Behälterunterteils 102 durchstoßen, an ihrer Außenseite stoffschlüssig mit der Wandung 124 verbunden, insbesondere durch Verschweißung, vorzugsweise durch Laserverschweißung.

Insbesondere kann vorgesehen sein, dass die Außenseite jeder oberen Medium-Durchführung 128 längs einer an der Innenseite der Wandung 124 um die betreffende obere Medium-Durchführung 128 umlaufende innere Schweißnaht 140 und durch eine an der Außenseite der Wandung 124 um die jeweilige obere Medium-Durchführung 128 umlaufende äußere Schweißnaht 142 stoffschlüssig mit der Wandung 124 verbunden ist.

Zumindest die dem Innenraum 112 des Prozessbehälters 100 zugewandten Oberflächen des Behälterunterteils 102 des Behälteroberteils 104 und der oberen Medium-Durchführungen 128 sowie die Innenflächen der oberen Medium-Durchführungen 128 und der unteren Medium-Durchführung 118 weisen vorzugsweise eine solche Oberflächenbeschaffenheit auf, dass Einlagerungen von Partikeln und Bakterien in diesen Oberflächen verhindert werden.

Insbesondere kann vorgesehen sein, dass diese Oberflächen eine Oberflächenrauigkeit (auch Rautiefe genannt) von weniger als 0,8 µm aufweisen.

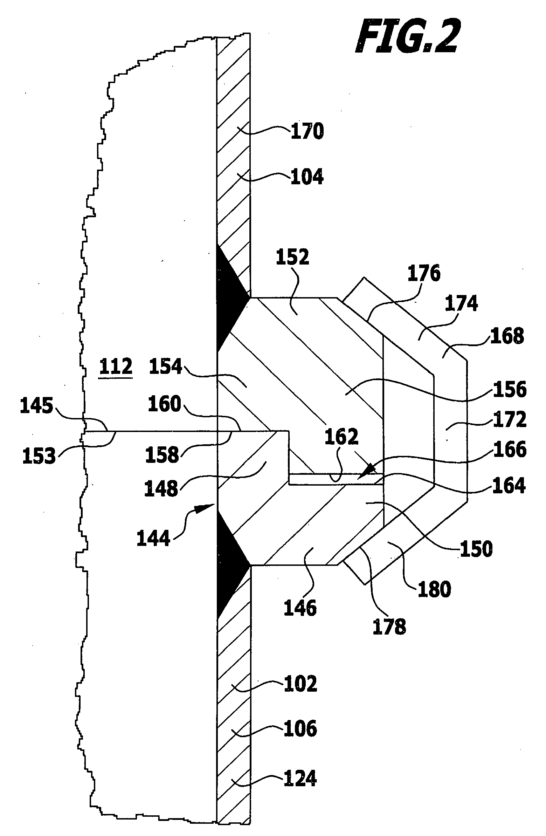

Das Behälterunterteil 102 und das abnehmbare Behälteroberteil 104 sind durch eine als Ganzes mit 144 bezeichnete, totraumfreie und spaltfreie Dichtungsanordnung 144 miteinander verbunden, die in Fig. 2 im Detail dargestellt ist.

Die Dichtungsanordnung 144 umfasst einen am oberen Rand 145 des Behälterunterteils 102 angeordneten gestuften Stützflansch 146 mit einem nach oben vorspringenden radial innenliegenden Abschnitt 148 und einem niedrigeren radial außenliegenden Abschnitt 150 sowie einen komplementär zum Stützflansch 146 gestuften Auflageflansch 152, der an einem unteren Rand 153 des Behälteroberteils 104 angeordnet ist und einen kürzeren radial innenliegenden Abschnitt 154 sowie einen nach unten zu dem Behälterunterteil 102 hin vorspringenden, längeren radial außenliegenden Abschnitt 156 umfasst.

Der radial innenliegende Abschnitt 154 des Auflageflansches 152 liegt mit seiner Unterseite, welche eine obere Dichtfläche 158 der Dichtungsanordnung 144 bildet, flächig auf einer Oberseite des radial innenliegenden Abschnitts 148 des Stützflansches 146 auf, welche eine untere Dichtfläche 160 der Dichtungsanordnung 144 bildet.

Zum Innenraum 112 des Prozessbehälters 100 hin sind der Stützflansch 146 und der Auflageflansch 152 im Wesentlichen flächenbündig ausgebildet, so dass in der Dichtungsanordnung 144 kein Totraum in Form einer sich radial nach außen erstreckenden Ausnehmung oder eines sich radial nach außen erstreckenden Spaltes ausgebildet ist, in welchem sich Verschmutzungen festsetzen könnten.

Zwischen der Unterseite 162 des radial außenliegenden Abschnitts 156 des Auflageflansches 152 und der Oberseite 164 des radial außenliegenden Abschnitts 150 des Stützflansches 146 ist hingegen vorzugsweise ein Spalt 166 ausgebildet, um an dieser Stelle, an welche keine Verschmutzungen aus dem Innenraum 112 gelangen können, einen Toleranzausgleich zu ermöglichen.

Der Stützflansch 146 und der Auflageflansch 152 sind mittels eines den Prozessbehälter 100 ringförmig umgebenden Spannelements 168 gegeneinander verspannt und formschlüssig aneinander gehalten.

Das Spannelement 168 kann einen mittleren, im Wesentlichen parallel zur Wandung 124 des oberen Abschnitts 106 des Behälterunterteils 102 und parallel zur Wandung 170 des Behälteroberteils 104 ausgerichteten Mittelabschnitt 172 sowie einen, vorzugsweise schräg zur Vertikalen und schräg zur Horizontalen ausgerichteten, oberen Abschnitt 174, welcher an einer Anlageschräge 176 des radial außenliegenden Abschnitts 156 des Auflageflansches 152 anliegt, und einen, ebenfalls vorzugsweise schräg zur Horizontalen und schräg zur Vertikalen ausgerichteten, unteren Abschnitt 178 umfassen, der an einer Anlageschräge 180 des radial außenliegenden Abschnitts 150 des Stützflansches 146 anliegt.

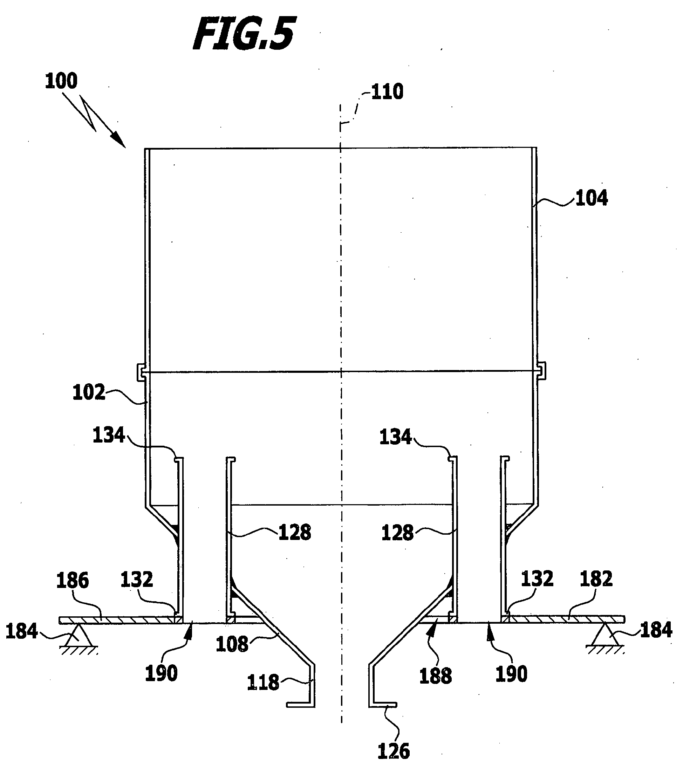

Um den Prozessbehälter 100 standsicher aufzustellen, kann derselbe mit einem Aufnahmeelement 182 versehen sein, mittels welchem der Prozessbehälter 100 an einer externen Lagerung 184 abstützbar ist (siehe Fig. 5).

Das Aufnahmeelement 182 kann insbesondere als eine im Wesentlichen ringförmige Aufnahmeplatte 186 ausgebildet sein, welche eine mittige Durchtrittsöffnung 188 für den Durchtritt des unteren Abschnitts 108 des Behälterunterteils 102 durch die Aufnahmeplatte 186 und eine der Anzahl der oberen Medium-Durchführungen 128 entsprechende Anzahl von Medium-Durchtrittsöffnungen 190 aufweist.

Die Medium-Durchtrittsöffnungen 190 sind dabei so an der Aufnahmeplatte 186 angeordnet, dass sie mit den Innenräumen der jeweils zugeordneten oberen Medien-Durchführungen 128 des Prozessbehälters 100 fluchten, wenn die Aufnahmeplatte 186 an die außenraumseitigen Adapter 132 der oberen Medium-Durchführungen 128 des Prozessbehälters 100 adaptiert (angeschlossen) ist.

Die Lagerungen 184 können grundsätzlich beliebiger Art sein; beispielsweise kann es sich hierbei um Lagerelemente einer Behandlungsvorrichtung handeln, von welcher der Prozessbehälter 100 einen Bestandteil bildet.

In Fig. 6 ist schematisch eine Behandlungsvorrichtung dargestellt, welche zusätzlich zu dem Prozessbehälter 100 ein Handhabungsgerät 192, beispielsweise in Form eines Roboters 194, umfasst, mittels welchem ein zu behandelndes Werkstück 196 in den Innenraum 112 des Prozessbehälters 100 einbringbar ist.

Das Handhabungsgerät 192 weist eine Greifvorrichtung 198 zum Ergreifen und Festhalten des Werkstücks 196 sowie einen Roboterarm 200 mit einer Mehrzahl von Drehgelenken 202, beispielsweise mit sechs Drehgelenken 202, auf. Im in Fig. 6 dargestellten Ausführungsbeispiel ist der Roboterarm 200 an einer Wand der Behandlungsvorrichtung, beispielsweise an einer Deckenwand 204, befestigt, so dass die Anzahl der Drehgelenke 202 des Roboterarms 200 der Anzahl der Bewegungsfreiheitsgrade des Handhabungsgeräts 192 entspricht.

Im dargestellten Ausführungsbeispiel beträgt die Anzahl der Bewegungsfreiheitsgrade des Handhabungsgeräts 192 sechs.

Vorzugsweise beträgt die Anzahl der Bewegungsfreiheitsgrade des Handhabungsgeräts 192 mindestens drei, besonders bevorzugt mindestens vier, insbesondere mindestens fünf.

Mittels des Handhabungsgeräts 192 kann ein Werkstück 196 im Außenraum 116 des Prozessbehälters 100 aufgenommen, für einen Behandlungsvorgang in den Innenraum 112 des Prozessbehälters 100 eingebracht und nach abgeschlossener Behandlung aus dem Prozessbehälter 100 entnommen werden.

Nach der Entnahme aus dem Prozessbehälter 100 kann das Werkstück 196 in einen oder mehrere weitere Prozessbehälter 100 der Behandlungsvorrichtung für weitere Behandlungsvorgänge eingebracht werden.

Nach Abschluss des letzten Behandlungsvorgangs kann das Werkstück 196 vom Handhabungsgerät 192 auf einer Werkstückablage oder auf einer Werkstück-Transportvorrichtung (nicht dargestellt) abgesetzt werden.

Es ist auch möglich, dass die Behandlungsvorrichtung mehrere Handhabungsgeräte 192 umfasst, welche das Werkstück 196 nacheinander aufnehmen, in den Innenraum 112 mindestens eines Prozessbehälters 100 einbringen und nach einem Behandlungsvorgang im Innenraum 112 eines Prozessbehälters 100 wieder aus dem Prozessbehälter 100 herausbewegen.

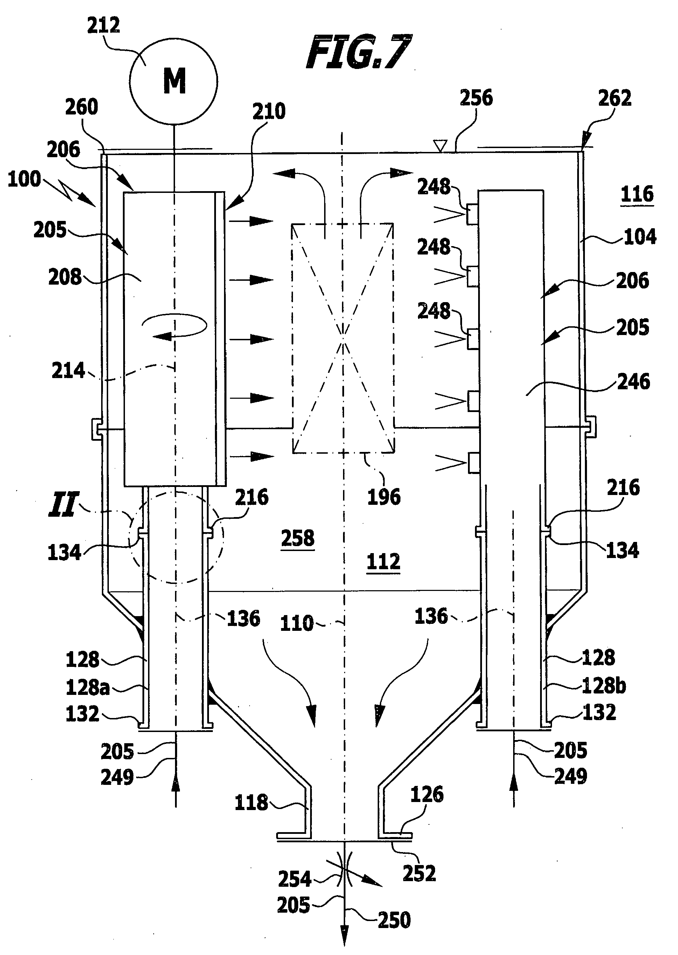

Der vorstehend beschriebene Prozessbehälter 100 kann multifunktional verwendet werden, indem jeweils andere Prozesselemente 205, beispielsweise Behandlungseinheiten 206 (siehe beispielsweise Fig. 7), im Innenraum 112 des jeweiligen Prozessbehälters 100 angeordnet werden, um eine jeweils spezifische Behandlung an einem Werkstück 196 auszuführen.

So ist beispielsweise der in Fig. 7 dargestellte Prozessbehälter 100 zur Durchführung eines Injektionsflutwaschens ausgerüstet.

Hierzu ist an den innenraumseitigen Adapter 134 einer der oberen Medium-Durchführungen 128 des Prozessbehälters 100, beispielsweise einer ersten oberen Medium-Durchführung 128a, als Prozesselement 205 eine Behandlungseinheit 206 in Form eines beweglichen Düsensystems 208 adaptiert.

Das bewegliche Düsensystems 208 umfasst beispielsweise eine Spaltdüse 210, durch welche ein flüssiges Waschmedium gezielt auf ein Werkstück 196 gerichtet werden kann, welches mittels eines (in Fig. 7 nicht dargestellten) Handhabungsgeräts 192 in dem Innenraum 112 des Prozessbehälters 100 gehalten wird.

Die Spaltdüse 210 ist mittels eines motorischen, pneumatischen oder hydraulischen Drehantriebs 212 um eine Drehachse 214 drehbar, welche vorzugsweise mit der Längsmittelachse 136 der betreffenden oberen Medium-Durchführung 128a zusammenfällt.

Die Behandlungseinheit 206 umfasst für den Anschluss an den innenraumseitigen Adapter 134 der oberen Medium-Durchführung 128 einen an der Unterseite der Behandlungseinheit 206 angeordneten Adapter 216.

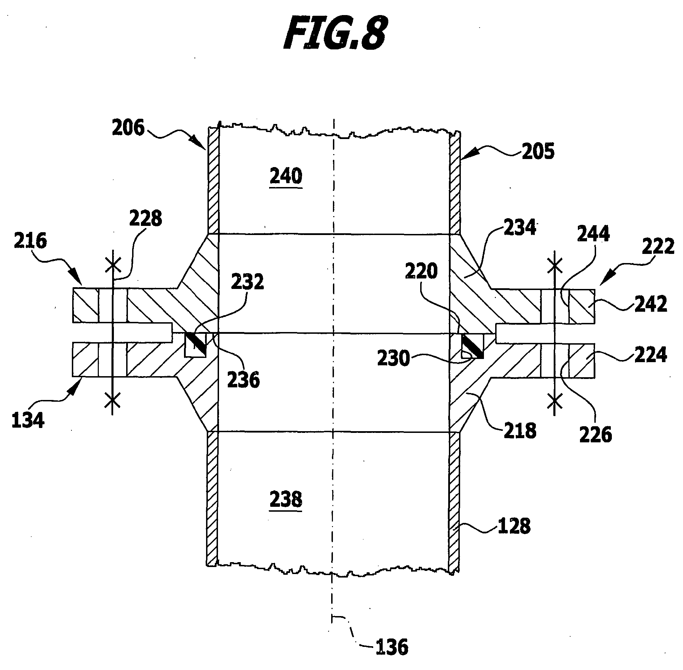

In Fig. 8 ist der Adapter 216 und der mit demselben zusammenwirkende innenraumseitige Adapter 134 der oberen Medium-Durchführung 128 im Einzelnen dargestellt.

Der innenraumseitige Adapter 134 der oberen Medium-Durchführung 128 umfasst einen radial innenliegenden, ringförmigen Stützabschnitt 218, dessen Oberseite eine untere Dichtfläche 220 der durch die beiden Adapter 134 und 216 gebildeten Dichtungsanordnung 222 bildet.

Von der unteren Dichtfläche 220 in Richtung der Längsmittelachse 136 der oberen Medium-Durchführung 136 nach unten beabstandet ist ein radial außenliegender, ringförmiger Befestigungsabschnitt 224 des innenraumseitigen Adapters 134 angeordnet, welcher in radialer Richtung von dem Stützabschnitt 218 nach außen vorsteht.

In dem Befestigungsabschnitt 224 sind mehrere, beispielsweise mindestens drei, Durchtrittsbohrungen 226 für den Durchtritt jeweils eines (in Fig. 8 nur rein schematisch durch seine Längsachse dargestellten) Befestigungsmittels 228, beispielsweise jeweils einer Befestigungsschraube, im Wesentlichen parallel zur Längsmittelachse 136 der oberen Medium-Durchführung 128 vorgesehen.

Vorzugsweise sind die Durchtrittsbohrungen 226 längs des Umfangs des Befestigungsabschnitts 224 in konstanten Winkelabständen bezüglich der Längsmittelachse 136 angeordnet.

An der unteren Dichtfläche 220 des Stützabschnitts 218 mündet eine Ringnut 230, in welcher ein ringförmiges Dichtelement 232, vorzugsweise aus elastomerem Material, angeordnet ist.

Der Adapter 216 der Behandlungseinheit 206 umfasst einen radial innenliegenden, ringförmigen Auflageabschnitt 234, dessen Unterseite eine obere Dichtfläche 236 der Dichtungsanordnung 222 bildet und flächig an der unteren Dichtfläche 220 anliegt, wobei das ringförmige Dichtelement 232 unter elastischer Vorspannung gegen die obere Dichtfläche 236 gepresst wird und somit eine ringförmige Dichtlinie ausbildet.

Die radial innenliegenden Begrenzungswände des Auflageabschnitts 234 des Adapters 216 und des Stützabschnitts 218 des innenraumseitigen Adapters 134 fluchten im Wesentlichen miteinander, so dass der Innenraum 238 der oberen Medium-Durchführung 128 und der Innenraum 240 der Behandlungseinheit 206 an ihren Rändern glatt und stufenlos ineinander übergehen und die Dichtungsanordung 222 totraumfrei und spaltfrei ausgebildet ist.

Der Adapter 216 der Behandlungseinheit 206 umfasst ferner einen in Richtung der Längsmittelachse 136 gegenüber der oberen Dichtfläche 236 nach oben versetzten, radial außenliegenden, ringförmigen Befestigungsabschnitt 242, der von dem Auflageabschnitt 234 des Adapters 216 in radialer Richtung nach außen vorspringt und mit mehreren, beispielsweise mit mindestens drei, Durchtrittsbohrungen 244 für den Durchtritt jeweils eines Befestigungsmittels 228 durch den Befestigungsabschnitt 242 versehen ist.

Die Durchtrittsbohrungen 244 im Befestigungsabschnitt 242 des Adapters 216 der Behandlungseinheit 206 sind im montierten Zustand der Behandlungseinheit 206 im Wesentlichen fluchtend mit den Durchtrittsbohrungen 226 im Befestigungsabschnitt 224 des innenraumseitigen Adapters 134 der jeweils zugeordneten oberen Medium-Durchführung 128 angeordnet, so dass jeweils ein Befestigungsmittel 228 sich durch eine Durchtrittsbohrung 244 im Adapter 216 und eine Durchtrittsbohrung 226 im Adapter 134 hindurch erstreckt.

Jedes der Befestigungsmittel 228 kann mittels eines Arretiermittels, beispielsweise mittels einer Befestigungsmutter (nicht dargestellt), in seiner Stellung an den Befestigungsabschnitten 224 und 242 arretiert und gegen ein Hinausbewegen aus den Durchtrittsbohrungen 226 und 244 gesichert sein.

Mittels der Befestigungsmittel 228 und der jeweils zugeordneten Arretiermittel können somit der Adapter 216 der Behandlungseinheit 206 und der Adapter 134 der Medium-Durchführung 128 gegeneinander verspannt werden.

Da die innenraumseitigen Adapter 134 aller oberen Medium-Durchführungen 128 des Prozessbehälters 100 identisch miteinander ausgebildet sind, kann die Behandlungseinheit 206 mit dem Adapter 216 an jede beliebige der oberen Medium-Durchführungen 128 adaptiert (angeschlossen) werden.

Vorzugsweise weist eine Behandlungsvorrichtung mehrere Prozessbehälter 100 mit oberen Medium-Durchführungen 128 auf, deren innenraumseitige Adapter 134 miteinander identisch sind, so dass ein und dieselbe Behandlungseinheit 206 an die oberen Medium-Durchführungen 128 verschiedener Prozessbehälter 100 adaptierbar ist.

Ferner weisen vorzugsweise verschiedene Prozesselemente 205, insbesondere Behandlungseinheiten 206, miteinander identische Adapter 216 auf, so dass diese verschiedenen Prozesselemente 205, insbesondere Behandlungseinheiten 206, wahlweise an dieselbe obere Medium-Durchführung 128 des Prozessbehälters 100 adaptiert werden können.

Vorzugsweise sind diese Prozesselemente 205, insbesondere Behandlungseinheiten 206, unterschiedlich ausgebildet, so dass unterschiedliche Arten von Behandlungen mit den verschiedenen Prozesselementen 205, insbesondere Behandlungseinheiten 206, an einem Werkstück 196 durchgeführt werden können.

Bei der in Fig. 7 dargestellten Konfiguration des Prozessbehälters 100 für einen Injektionsflutwaschvorgang kann an eine zweite obere Medium-Durchführung 128b als Prozesselement 205 und Behandlungseinheit 206 ein starres Düsensystem 246 adaptiert sein.

Dabei weist das starre Düsensystem 246 als Prozesselement 205 einen Adapter 216 auf, welcher mit dem vorstehend bereits beschriebenen Adapter 216 des beweglichen Düsensystems 208 identisch ist, so dass dieser Adapter 216 an den mit dem innenraumseitigen Adapter 134 der ersten oberen Medium-Durchführung 128a identischen innenraumseitigen Adapter 134 der zweiten oberen Medium-Durchführung 128b adaptierbar ist.

Das starre Düsensystem 246 weist mehrere, beispielsweise fünf, Waschmediumdüsen 248 auf, mittels denen jeweils ein auf das Werkstück 196 gerichteter Waschmedium-Strahl erzeugbar ist.

Die Waschmedium-Düsen 248 sind vorzugsweise in Richtung der Längsmittelachse 136 der oberen Medien-Durchführung 128b voneinander beabstandet.

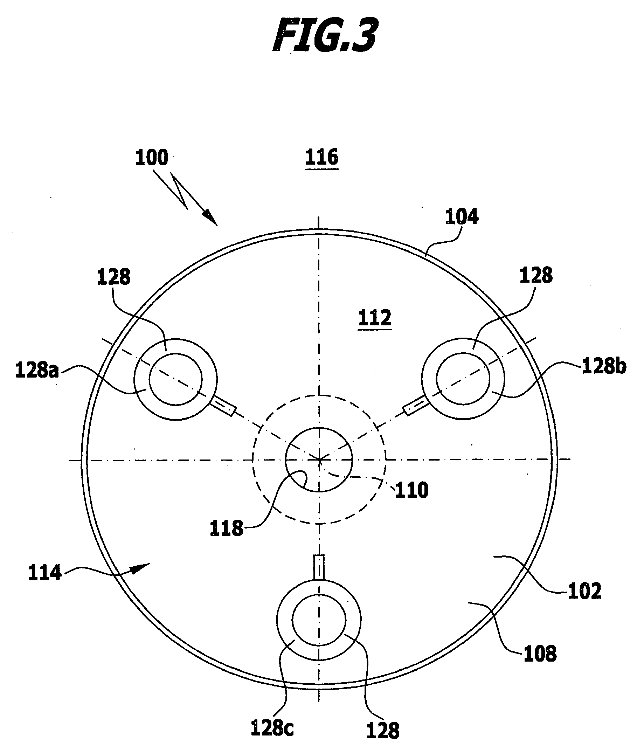

Die (in Fig. 7 nicht dargestellte) dritte obere Medium-Durchführung 128c (siehe Fig. 3) kann mit einem weiteren beweglichen Düsensystem 208 oder einem weiteren starren Düsensystems 246 versehen sein.

An die außenraumseitigen Adapter 132 aller drei oberen Medium-Durchführungen 128 des Prozessbehälters 100 ist bei der in Fig. 7 dargestellten Konfiguration jeweils eine Waschmedium-Zuführleitung 249 adaptiert.

Dabei ist jeder außenraumseitige Adapter 132 einer oberen Medien-Durchführung 128 beispielsweise spiegelbildlich zu dem in Fig. 8 dargestellten innenraumseitigen Adapter 134 ausgebildet.

Der (nicht dargestellte) Adapter jeder Waschmedium-Zuführleitung 249 ist vorzugsweise im Wesentlichen spiegelbildlich zu dem in Fig. 8 dargestellten Adapter 216 der Behandlungseinheit 206 ausgebildet.

An den außenraumseitigen Adapter 126 der unteren Medium-Durchführung 118 des Prozessbehälters 100 ist bei der in Fig. 7 dargestellten Konfiguration eine Waschmedium-Abführleitung 250 adaptiert.

Dabei kann der (außenraumseitige) Adapter 126 der unteren Medium-Durchführung 118 im Wesentlichen gleich ausgebildet sein wie die außenraumseitigen Adapter 132 der oberen Medium-Durchführungen 128 und der Adapter 252 der Waschmedium-Abführleitung 250 ist vorzugsweise im Wesentlichen gleich ausgebildet wie die Adapter der Waschmedium-Zuführleitungen 249.

In der Waschmedium-Abführleitung 250 kann ein Sperrventil 254 mit einstellbarem durchströmbarem Querschnitt angeordnet sein.

Durch Schließen des Sperrventils 254 kann der Innenraum 112 des Prozessbehälters 100 zunächst durch Zufuhr des Wasch-Mediums über die Waschmedium-Zuführleitungen 249 und die Düsensysteme 208 und 246 mit dem Waschmedium befüllt werden, bis der Badpegel 256 eines Waschmedium-Bades 258 im Innenraum 112 des Prozessbehälters 100 den oberen Rand 260 des Behälteroberteils 104 erreicht und bei weiterer Zufuhr von Waschmedium zu dem Innenraum 112 oder beim Eintauchen eines Werkstücks 196 in das Waschmedium-Bad 258 überschüssiges Waschmedium über den als Überlauf 262 dienenden oberen Rand 260 übertritt und in ein (nicht dargestelltes) Waschmedium-Auffangbecken abfließt.

Durch diesen Überlauf des Waschmediums über den oberen Rand 260 des Prozessbehälters 100 können Schwebepartikel und Öle, welche eine geringere Dichte als das Waschmedium aufweisen, aus dem Innenraum 112 des Prozessbehälters 100 entfernt werden.

Schwere Schmutzpartikel sinken hingegen in dem Waschmedium-Bad 258 nach unten und werden durch die untere Medium-Durchführung 118 und die Waschmedium-Abführleitung 250 abgeführt, nachdem das Sperrventil 254 geöffnet worden ist.

Durch die Erzeugung von auf das Werkstück 196 gerichteten Waschmedium-Strahlen innerhalb des Waschmedium-Bades 258 wird das in das Waschmedium-Bad 258 (vorzugsweise im Wesentlichen vollständig) eingetauchte Werkstück 196 einem Injektionsflutwaschvorgang unterzogen.

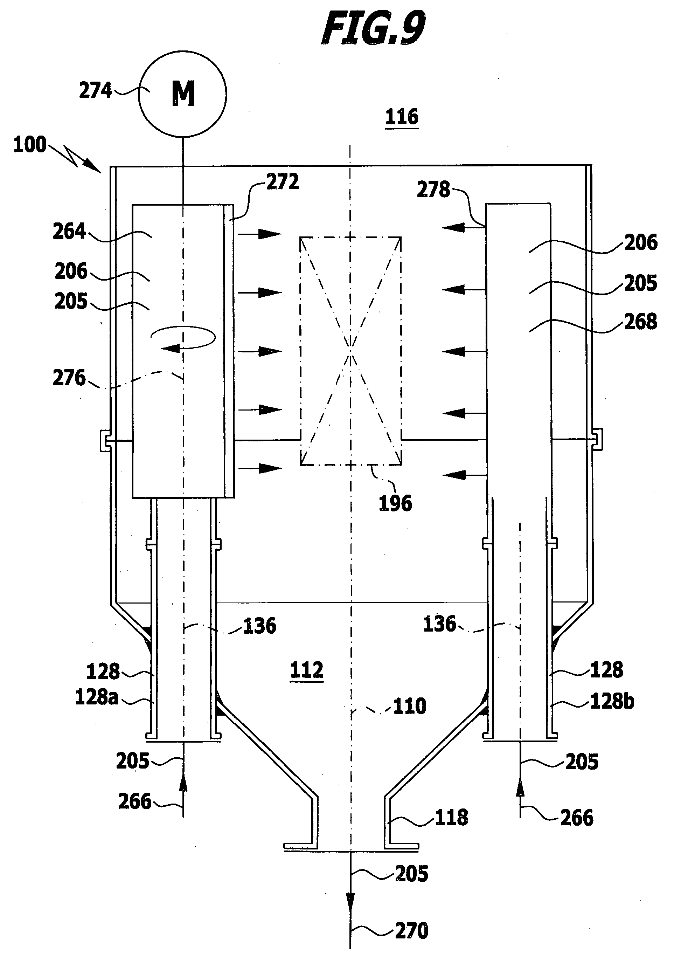

Bei einer in Fig. 9 dargestellten alternativen Konfiguration des Prozessbehälters 100 wird derselbe zur Durchführung eines Abblasvorgangs an einem Werkstück 196 verwendet.

Hierzu ist an die erste obere Medium-Durchführung 128a innenraumseitig ein bewegliches Blasdüsensystem 264 als Prozesselement 205 und Behandlungseinheit 206 und außenraumseitig eine Blasluftzuführleitung 266 als Prozesselement 205 adaptiert.

An die zweite obere Medium-Durchführung 128b ist innenraumseitig ein starres Blasdüsensystem 268 als Prozesselement 205 und Behandlungseinheit 206 und außenraumseitig ebenfalls eine Blasluftzuführleitung 266 als Prozesselement 205 adaptiert.

Die (nicht dargestellte) dritte obere Medium-Durchführung 128 kann mit einem beweglichen Blasdüsensystem 264 oder mit einem starren Blasdüsensystem 268 versehen sien.

Die untere Medium-Durchführung 118 ist außenraumseitig mit einer Abführleitung 270 für Schmutzpartikel und von dem Werkstück 196 abgeblasener Flüssigkeit als Prozesselement 205 verbunden.

Das bewegliche Blasendüsensystem 264 kann eine Spaltdüse 272 aufweisen, mittels welcher ein gegen das Werkstück 196 gerichteter Blasluftstrahl erzeugbar ist und welche mittels eines motorischen Drehantriebs 274 um eine, vorzugsweise parallel zu der Längsmittelachse 136 der oberen Medium-Durchführung 128a verlaufende, Drehachse 276 drehbar ist.

Das starre Blasdüsensystem 268 ist mit mehreren, beispielsweise fünf, Blasluftdüsen 278 versehen, mit welchen jeweils ein gegen das Werkstück 196 gerichteter Blasluftstrahl erzeugbar ist.

Die Blasluftdüsen 278 sind vorzugsweise längs der Längsmittelachse 136 der jeweils zugeordneten oberen Medium-Durchführung 128 voneinander beabstandet angeordnet.

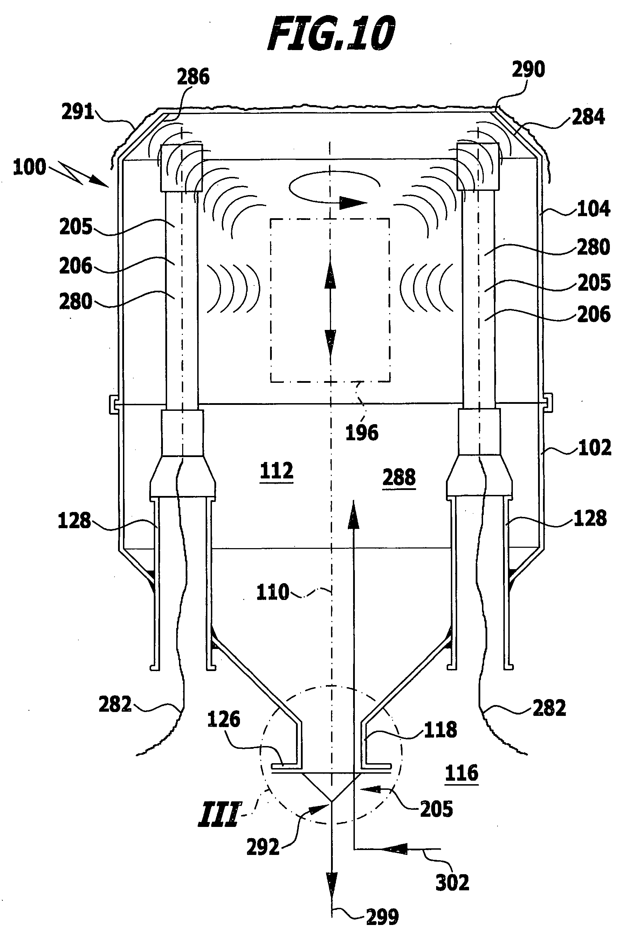

In einer in Fig. 10 dargestellten alternativen Konfiguration wird der Prozessbehälter 100 zur Durchführung eines Ultraschallreinigungsvorgang an einem Werkstück 196 verwendet.

Hierzu ist an jede der oberen Medium-Durchführungen 128 des Prozessbehälters 100 als Prozesselement 205 und Behandlungseinheit 206 innenraumseitig jeweils ein Ultraschallschwinger 280 adaptiert.

Durch jede der oberen Medium-Durchführungen 128 erstreckt sich bei dieser Ausführungsform jeweils eine Energiezuführung 282 zum jeweils zugeordneten Ultraschallschwinger 280 hindurch.

Bei dieser Konfiguration des Prozessbehälters 100 bildet somit elektrische Energie das Medium, welches durch die oberen Medium-Durchführungen 128 vom Außenraum 116 in den Innenraum 112 des Prozessbehälters 100 hindurchgeführt wird.

Das im Bereich zwischen den Ultraschallschwingern 280 angeordnete Werkstück 196 wird bei dieser Verwendung des Prozessbehälters 100 vorzugsweise mittels des Handhabungsgeräts 192 auf und ab bewegt und/oder gedreht, damit alle Oberflächen des Werkstücks 196 von den Ultraschallwellen, welche mittels der Ultraschallschwinger 280 erzeugt werden, beaufschlagt werden.

Damit auch von den Ultraschallschwingern 280 erzeugte und zunächst von dem Werkstück 196 weg gerichtete Ultraschallwellen zu dem Werkstück 196 hin reflektiert werden, ist der Prozessbehälter 100 bei dieser Konfiguration mit einem auf das Behälteroberteil 104 aufgesetzten ringförmigen Reflektionsschirm 284 versehen, dessen (beispielsweise im Wesentlichen kegelstumpfmantelförmige) Innenseite eine Reflektionsfläche 286 für die Ultraschallwellen bildet.

Als Medium zur Übertragung der Ultraschallwellen von den Ultraschallschwingern 280 zu dem Werkstück 196 dient bei dieser Konfiguration ein Reinigungsmedium-Bad 288, mit welchem der Prozessbehälter 100 bis zum oberen Rand 290 des Reflektionsschirms 284 gefüllt ist, welcher einen Überlauf für das Reinigungsmedium bildet.

Über diesen Überlauf werden Schwebstoffe und Öle (in Fig. 10 schematisch mit 291 bezeichnet), welche eine geringere Dichte als das Reinigungsmedium aufweisen, aus dem Innenraum 112 des Prozessbehälters 100 abgeführt.

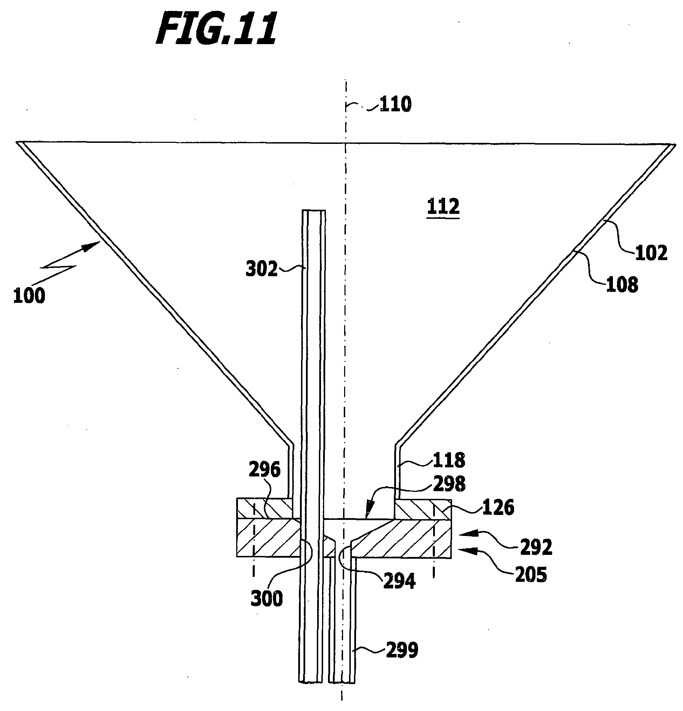

Die Zufuhr des Reinigungsmediums in den Innenraum 112 des Prozessbehälters 100 und die Abfuhr von Reinigungsmedium mit darin enthaltenen schweren Schmutzpartikeln erfolgt bei der in Fig. 10 dargestellten Konfiguration des Prozessbehälters 100 mittels des in Fig. 11 im Detail dargestellten kombinierten Ab- und Zulaufanschlusses 292, welcher als Prozesselement 205 an den außenraumseitigen Adapter 126 der unteren Medium-Durchführung 118 angeschlossen ist.

Der Ab- und Zulaufanschluss 292 umfasst eine im Wesentliche mittige Ablaufbohrung 294, welche sich zu der Oberseite 296 des Ab- und Zulaufanschlusses 292 hin trichterförmig erweitert, so dass der Durchmesser der Mündungsöffnung 298 der Ablaufbohrung 294 an der Oberseite 296 des Ab- und Zulaufanschlusses 292 im Wesentlichen dem Innendurchmesser der unteren Medium-Durchführung 118 entspricht.

Mit dem der unteren Medium-Durchführung 118 abgewandten Ende der Ablaufbohrung 294 ist fluiddicht eine Ablaufleitung 298 verbunden.

Ferner umfasst der Ab- und Zulaufanschluss 292 eine Durchgangsbohrung 300, in welche eine Zulaufleitung 302 fluiddicht eingesetzt ist.

Die Zulaufleitung 302 erstreckt sich durch die untere Medium-Durchführung 118 hindurch in den Innenraum 112 des unteren Abschnitts 108 des Behälterunterteils 102 des Prozessbehälters 100 hinein und verläuft vorzugsweise im Wesentlichen parallel zur Mittelachse 110 des Prozessbehälters 100.

Die Zulaufleitung 302 kann insbesondere durch den trichterförmigen Abschnitt der Ablaufbohrung 294 verlaufen.

Die Ablaufleitung 298 ist vorzugsweise so dimensioniert, dass höchstens 70 % des durch die Zulaufleitung 302 in den Innenraum 112 des Prozessbehälters 100 zugeführten Reinigungsmediums durch die Ablaufleitung 298 abläuft, während mindestens 30 % des zugeführten Reinigungsmediums über den einen Überlauf bildenden oberen Rand 290 des Reflektionsschirms 284 aus dem Innenraum 112 des Prozessbehälters 100 hinaus gelangt.

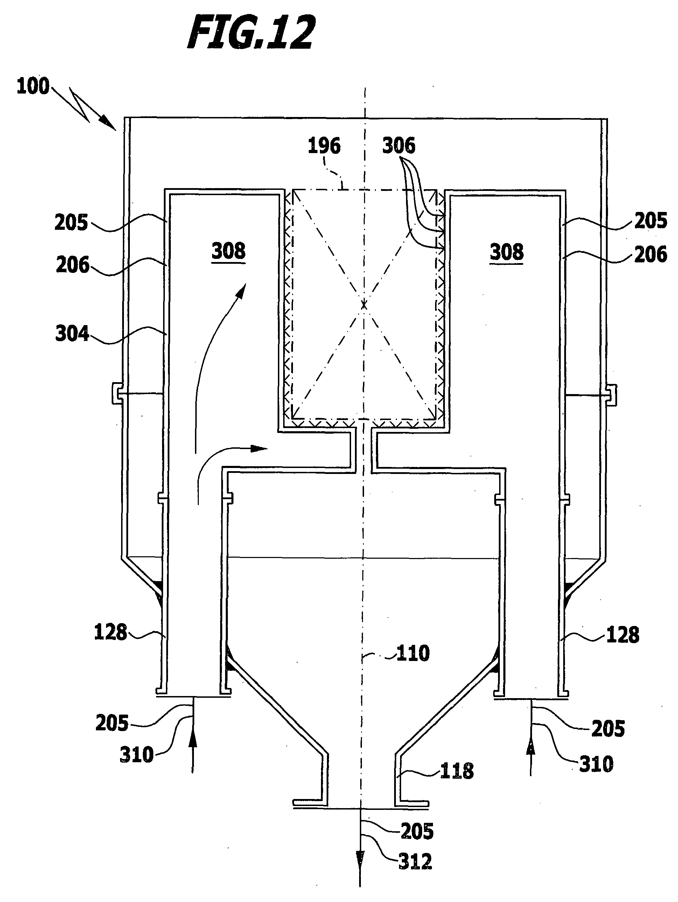

Eine in Fig. 12 dargestellte alternative Konfiguration des Prozessbehälters 100 dient zur Durchführung eines Spritzreinigungsvorgangs an einem Werkstück 196.

Hierfür ist an mindestens zwei der oberen Medium-Durchführungen 128 des Prozessbehälters 100 jeweils ein an die Außenkontur des zu behandelnden Werkstücks 196 angepasstes Spritzdüsensystem 304 als Prozesselement 205 und Behandlungseinheit 206 adaptiert.

Jedes der Spritzdüsensysteme 304 umfasst mehrere Spritzdüsen 306, mittels welcher jeweils ein auf das Werkstück 196 gerichteter Spritzstrahl eines Reinigungsmediums erzeugbar ist.

Dabei kann mindestens eine Spritzdüse 306 unterhalb des Werkstücks 196 in dessen Waschposition angeordnet sein, um einen von unten gegen das Werkstück 196 gerichteten Spritzstrahl zu erzeugen, und mindestens eine Spritzdüse kann seitlich neben dem Werkstück 196 in dessen Waschposition angeordnet sein, um einen im Wesentlichen horizontal von der Seite gegen das Werkstück 196 gerichteten Spritzstrahl zu erzeugen.

Die Spritzdüsen 306 des Spritzdüsensystems 304 stehen in Fluidverbindung mit einem Hohlraum 308 im Inneren des Spritzdüsensystems 304, welcher von dem auf das Werkstück 196 zu spritzenden Reinigungsmedium durchströmbar ist.

Außenraumseitig ist an jeder der oberen Medium-Durchführungen 128, an welche ein Spritzdüsensystem 304 angeschlossen ist, jeweils eine Reinigungsmedium-Zuführleitung 310 als Prozesselement 205 adaptiert.

An die untere Medium-Durchführung 118 des Prozessbehälters 100 ist bei dieser Konfiguration außenraumseitig eine Reinigungsmedium-Abführleitung 312 als Prozesselement 205 adaptiert.

Das mittels einer Spritzreinigung zu behandelnde Werkstück 196 kann während der Behandlung von dem Handhabungsgerät 192 in der Waschposition im Innenraum 112 in Nachbarschaft zu den Spritzdüsensystemen 304 gehalten oder auf einer (nicht dargestellten) Werkstückablage abgelegt werden.

Das Reinigungsmedium wird den Spritzdüsen 306 über die Reinigungsmedium-Zuführleitungen 310 zugeführt und wird, nachdem es das Werkstück 196 beaufschlagt hat, zusammen mit dem vom Werkstück 196 gelösten Schmutz durch die untere Medium-Durchführung 118 und die Reinigungsmedium-Abführleitung 312 aus dem Innenraum 112 des Prozessbehälters 100 abgeführt.

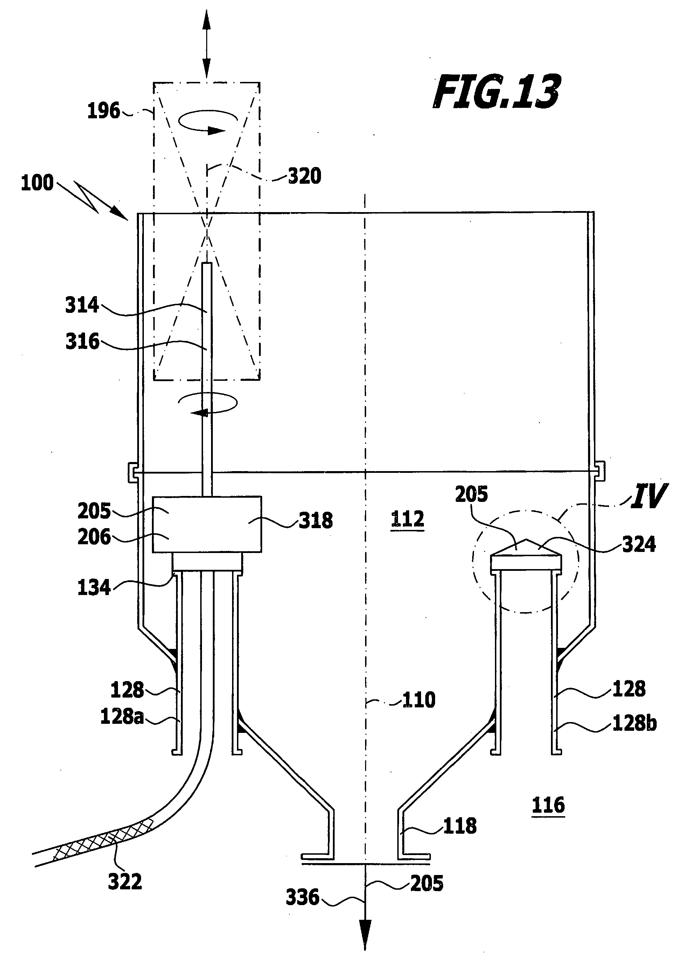

Eine in Fig. 13 dargestellte alternative Konfiguration des Prozessbehälters 100 dient zur Durchführung einer Hochdruckentgratung an einem Werkstück 196.

Hierfür ist eine der oberen Medium-Durchführungen 128 des Prozessbehälters 100, beispielsweise die erste obere Medium-Durchführung 128a, innenraumseitig mit einem Hochdruckwerkzeug 314 als Prozesselement 205 und Behandlungseinheit 206 versehen.

Das Hochdruckwerkzeug 314 umfasst vorzugsweise eine Düsenlanze 316, mit welcher ein auf Grate des zu entgratenden Werkstücks 196 gerichteter Hochdruckmediumstrahl erzeugbar ist.

Die Düsenlanze 316 kann mittels eines Rotationsantriebs 318, insbesondere um die Lanzenachse 320, drehbar gehalten sein.

Der Rotationsantrieb 318 ist vorzugsweise mittels eines geeigneten Adapters an den innenraumseitigen Adapter 134 der ersten oberen Medium-Durchführung 128a angeschlossen.

Durch die obere Medium-Durchführung 128a hindurch verläuft bei dieser Konfiguration eine Hochdruckmedium-Zuführleitung 322, welche das Hochdruckmedium von einer (nicht dargestellten) Hochdruckmediumquelle dem Hochdruckwerkzeug 314 zuführt.

Das Hochdruckmedium steht vorzugsweise unter einem Druck von mindestens 50 bar und von vorzugsweise höchstens 3000 bar.

Bei dem Hockdruckmedium kann es sich beispielsweise um Hochdruckwasser handeln.

Die übrigen oberen Medium-Durchführungen 128b und 128c sind bei dieser Konfiguration des Prozessbehälters 100 innenraumseitig mittels eines Verschlussdeckels 324 als Prozesselement 205 verschlossen, um zu verhindern, dass das für die Hochdruckentgratung verwendete Medium durch die nicht benutzten oberen Medium-Durchführungen 128b und 128c in den Außenraum 116 des Prozessbehälters 100 gelangt.

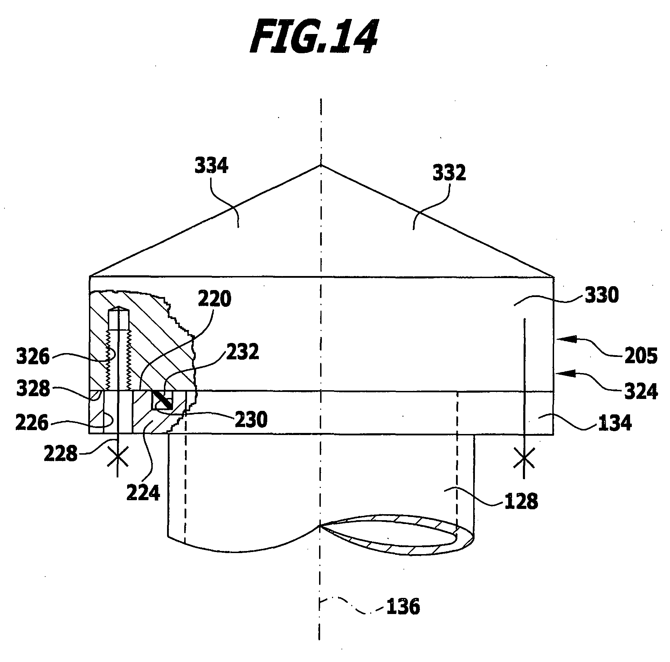

Wie aus Fig. 14 im Detail zu ersehen ist, ist der Verschlussdeckel 324 ebenso wie eine Behandlungseinheit 206 an den innenraumseitigen Adapter 134 der betreffenden oberen Medien-Durchführung 128 angeschlossen.

Zu diesem Zweck ist der Verschlussdeckel 324 längs seines Umfangs mit mehreren, beispielsweise drei, Gewindesacklöchern 326 versehen, welche mit jeweils einer Durchtrittsbohrung 226 im Befestigungsabschnitt 224 des innenraumseitigen Adapters 134 der oberen Medium-Durchführung 128 fluchtet, so dass ein geeignetes Befestigungsmittel 228, insbesondere eine Befestigungsschraube, durch die Durchtrittsbohrung 226 in das Gewindesackloch 326 eingebracht und dort eingedreht werden kann, um den Verschlussdeckel 324 und den innenraumseitigen Adapter 134 gegeneinander zu verspannen.

Eine Abdichtung zwischen dem Verschlussdeckel 324 und dem innenraumseitigen Adapter 134 wird dabei durch das ringförmige Dichtelement 232 erzielt, welches in der Ringnut 230 des innenraumseitigen Adapters 134 angeordnet ist und gegen die Unterseite 328 des Verschlussdeckels 324 gepresst wird.

Der Verschlussdeckel 324 kann einen im Wesentlichen zylindrischen unteren Abschnitt 330, in dem die Gewindesacklöcher 326 angeordnet sind, und einen sich nach oben an den unteren Abschnitt 330 anschließenden, pyramidenförmigen oder konischen oberen Abschnitt 332 umfassen, dessen gegen die Horizontale geneigte Außenfläche 334 dafür sorgt, dass sich an dem Verschlussdeckel 324 weder ein flüssiges Medium noch Schmutzpartikel ablagern können.

Da die Unterseite 328 des Verschlussdeckels 324 flächig an der unteren Dichtfläche 220 des innenraumseitigen Adapters 134 der oberen Medium-Durchführung 128 anliegt, wird eine totraumfreie und spaltfreie Dichtung zwischen dem Verschlussdeckel 324 und der oberen Medium-Durchführung 128 erzielt.

Da die nicht mit einem Hochdruckwerkzeug 314 bestückten Medium-Durchführungen 128b und 128c durch jeweils einen Verschlussdeckel 324 verschlossen sind, fließt das zur Hochdruckentgratung des Werkstücks 196 verwendete Medium mit den darin enthaltenen Partikeln, insbesondere Entgratungsresten, nur durch die untere Medium-Durchführung 118 und eine außenseitig als Prozesselement 205 daran adaptierte Medium-Abführleitung 336 aus dem Innenraum 112 des Prozessbehälters 100 ab.

Das Werkstück 196 wird mittels des Handhabungsgeräts 192 in den Arbeitsbereich des Hochdruckwerkzeugs 314 gebracht und während der Hochdruckentgratungsbehandlung mittels des Handhabungsgeräts 192 relativ zu dem Hochdruckwerkzeug 314 bewegt, insbesondere gedreht und/oder auf und ab bewegt.

Dabei kann der Innenraum 112 des Prozessbehälters 100 im Wesentlichen entleert oder aber, teilweise oder vollständig, mit einem flüssigen Medium, insbesondere mit dem zur Hochdruckentgratung verwendeten Medium, gefüllt sein.

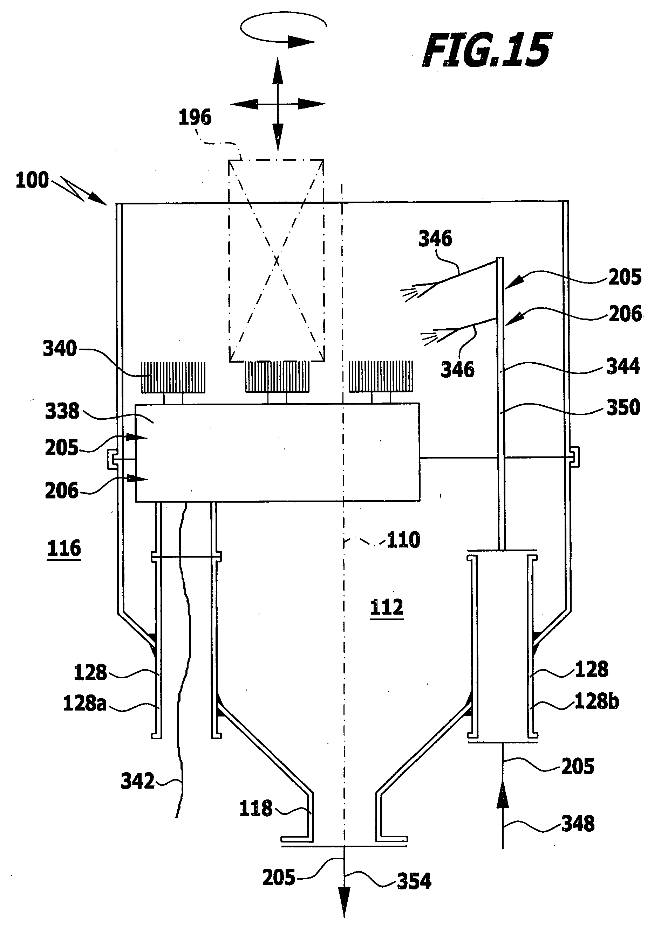

Eine in Fig. 15 dargestellte alternative Konfiguration des Prozessbehälters 100 dient zur Durchführung einer Bürstentgratung an einem Werkstück 196.

Hierfür ist an die erste obere Medium-Durchführung 128a innenraumseitig ein Bürstensystem 338 als Prozesselement 205 und Behandlungseinheit 206 adaptiert.

Das Bürstensystem 338 weist mehrere Entgratungsbürsten 340 auf, welche mittels einer (nicht dargestellten) Bewegungsvorrichtung in Bewegung versetzt werden können, um Grate an dem Werkstück 196 durch Abbürsten zu entfernen.

Eine Energiezuführung 342 zu dieser Bewegungseinrichtung verläuft bei der in Fig. 15 dargestellten Konfiguration durch die erste obere Medium-Durchführung 128a hindurch. Bei dieser Konfiguration ist somit die der Bewegungseinrichtung zuzuführende Energie das Medium, welches durch die obere Medium-Durchführung 128a hindurchgeführt wird.

An eine zweite obere Medium-Durchführung 128b ist innenraumseitig ein Spülsystem 334 als Prozesselement 205 und Behandlungseinheit 206 adaptiert.

Das Spülsystem 344 weist eine oder mehrere Spüldüsen 346 auf, mittels welcher jeweils ein auf das Werkstück 196 und/oder auf eine Entgratungsbürste 340 gerichteter Spülmediumstrahl erzeugbar ist.

Außenraumseitig ist an die zweite obere Medium-Durchführung 128b eine Spülmedium-Zuführleitung 348 als Prozesselement 205 adaptiert.

An die untere Medium-Durchführung 118 des Prozessbehälters 100 ist bei dieser Konfiguration außenraumseitig als Prozesselement 205 eine Abführleitung 354 angeschlossen, mittels welcher Bürstabrieb und Spülmedium aus dem Innenraum 112 des Prozessbehälters 100 abführbar ist.

Für die Durchführung eines Bürstentgratvorgangs wird das zu entgratende Werkstück 196 mittels des Handhabungsgeräts 192 in den Arbeitsbereich des Bürstensystems 338 gebracht und während des Bürstentgratungsvorgangs mittels des Handhabungsgeräts 192 relativ zu den Entgratungsbürsten 340 bewegt, und zwar insbesondere gedreht und/oder auf die Entgratungsbürten 340 zu oder von den Entgratungsbürsten weg bewegt und/oder in einer Längsrichtung der Entgratungsbürsten 340 bewegt.

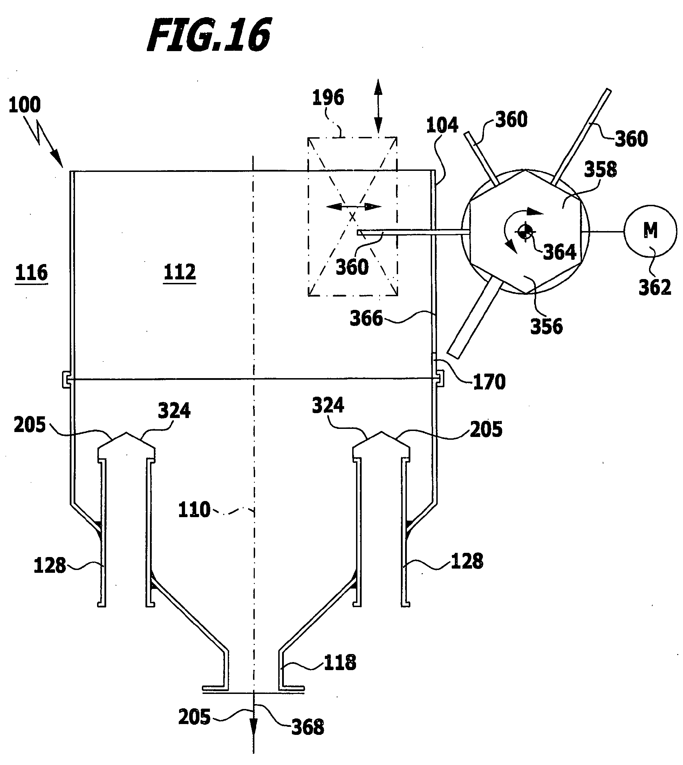

Eine in Fig. 16 dargestellte alternative Konfiguration des Prozessbehälters 100 dient ebenso wie die in Fig. 13 dargestellte Konfiguration der Durchführung eines Hochdruckentgratungsvorgangs an einem Werkstück 196, wobei in diesem Fall statt eines einzigen Hochdruckwerkzeugs ein Hochdruckwerkzeug-Revolver 356 mit einem Grundkörper 358, der mehrere verschiedene Hochdruckwerkzeuge 360 trägt, vorgesehen ist.

Der Grundkörper 358 ist mittels eines motorischen Drehantriebs 362 um eine beispielsweise im Wesentlichen horizontale Drehachse 364 drehbar, so dass wahlweise jeweils eines der Hochdruckwerkzeuge 360 durch einen in der Wandung 170 des Behälteroberteils 104 des Prozessbehälters 100 ausgebildeten Spalt 366 in den Innenraum 112 des Prozessbehälters 100 einschwenkbar ist, um eine Hochdruckentgratungsbehandlung an einem zumindest teilweise im Innenraum 112 des Prozessbehälters 100 angeordneten Werkstücks 196 durchzuführen.

An die untere Medium-Durchführung 118 ist bei dieser Konfiguration des Prozessbehälters 100 außenraumseitig als Prozesselement 205 eine Abführleitung 368 adaptiert, durch welche das für die Hochdruckentgratung verwendete Medium mit den darin enthaltenen Partikeln, insbesondere Entgratungsresten, aus dem Innenraum 112 des Prozessbehälters 100 abführbar ist.

Die oberen Medium-Durchführungen 128 sind bei dieser Konfiguration mittels jeweils eines als Prozesselement 205 innenraumseitig an die oberen Medium-Durchführungen 128 adaptierten Verschlussdeckels 324 verschlossen.

Das zu entgratende Werkstück 196 wird mittels des Handhabungsgeräts 192 in den Arbeitsbereich des jeweils in den Innenraum 112 des Prozessbehälters 100 eingebrachten Hochdruckwerkzeugs 360 gebracht und während des Entgratungsvorgangs relativ zu dem Hochdruckwerkzeug 360 bewegt, insbesondere gedreht und/oder in Richtung der Längsachse des Hochdruckwerkzeugs 360 bewegt und/oder auf und ab bewegt.

Als Hochdruckmedium kann bei dieser Konfiguration dasselbe Medium wie bei der Konfiguration aus Fig. 13 verwendet werden, also beispielsweise Wasser, das unter einem Druck von vorzugsweise mindestens ungefähr 50 bar und vorzugsweise höchstens ungefähr 3000 bar steht.

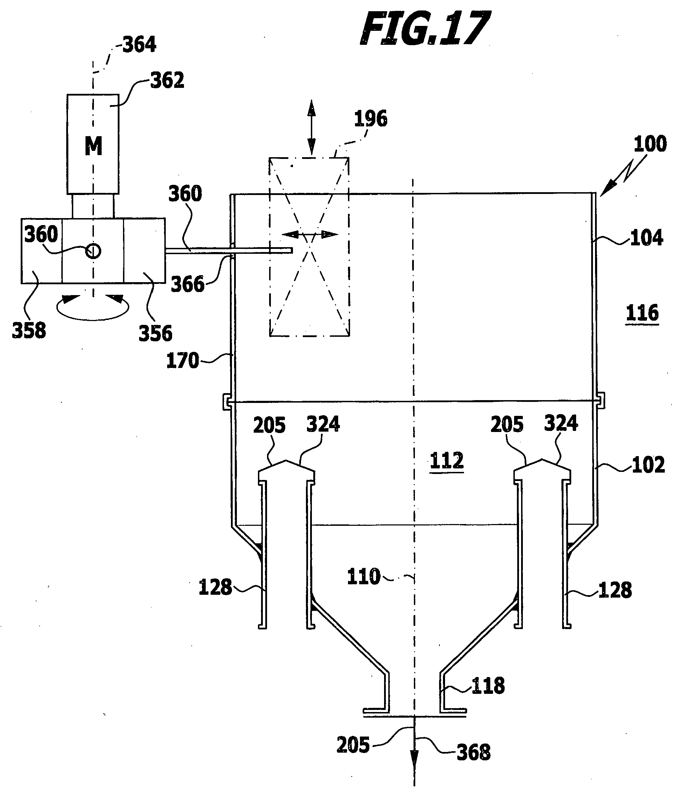

Eine in Fig. 17 dargestellte Variante der in Fig. 16 dargestellten Konfiguration des Prozessbehälters 100 unterscheidet sich von der in Fig 16 dargestellten Konfiguration lediglich dadurch, dass die Drehachse 364, um welche der Grundkörper 358 des Hochdruckwerkzeug-Revolvers 356 mittels des motorischen Drehantriebs 362 drehbar ist, nicht im Wesentlichen horizontal, sondern stattdessen im Wesentlichen vertikal ausgerichtet ist.

Im Übrigen stimmt die in Fig. 17 dargestellte Konfiguration des Prozessbehälters 100 hinsichtlich Aufbau und Funktion mit der in Fig. 16 dargestellten Konfiguration zum Hochdruckentgraten überein, auf deren vorstehende Beschreibung insoweit Bezug genommen wird.

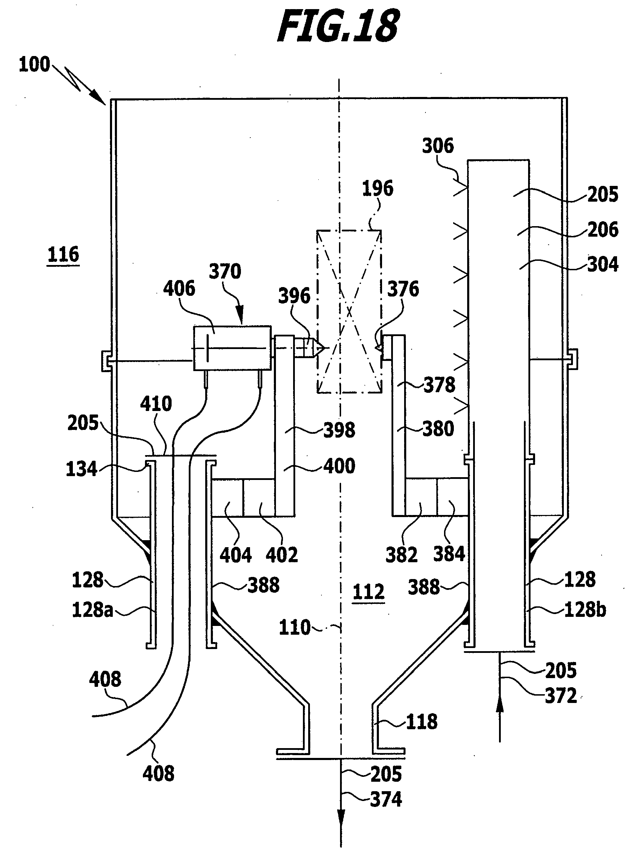

Eine in Fig. 18 dargestellte alternative Konfiguration des Prozessbehälters 100 dient zur Durchführung einer Spritzreinigung eines Werkstück 196, das mittels eines Arretiersystems 370 in einer Behandlungsposition im Innenraum 112 des Prozessbehälters 100 arretiert ist.

Hierfür ist an die zweite obere Medium-Durchführung 128b als Prozesselement 205 und Behandlungseinheit 206 innenraumseitig ein Spritzdüsensystem 304 mit mehreren Spritzdüsen 306 adaptiert.

Außenraumseitig ist an die zweite obere Medium-Durchführung 128b als Prozesselement 205 eine Prozessfluid-Zuführleitung 372 adaptiert, über welche den Spritzdüsen 306 des Spritzdüsensystems 304 ein Prozessfluid zuführbar ist, aus welchem das Spritzdüsensystem 304 auf das Werkstück 196 gerichtete Spritzstrahlen erzeugt.

An die untere Medium-Durchführung 118 ist bei dieser Konfiguration des Prozessbehälters 100 außenraumseitig als Prozesselement 205 eine Prozessfluid-Abführleitung 374 adaptiert, über welche Prozessfluid, welches das Werkstück 196 beaufschlagt hat, zusammen mit vom Werkstück 196 gelösten Schmutzpartikeln aus dem Innenraum 112 des Prozessbehälters 100 abführbar ist.

Das Arretiersystem 370 zum Arretieren des Werkstücks 196 in einer Behandlungsposition im Innenraum 112 des Prozessbehälters 100 umfasst ein.stationäres Spannelement 376, das an einem Haltewinkel 378 mit einem vertikalen Schenkel 378 und einem horizontalen Schenkel 382 angeordnet ist.

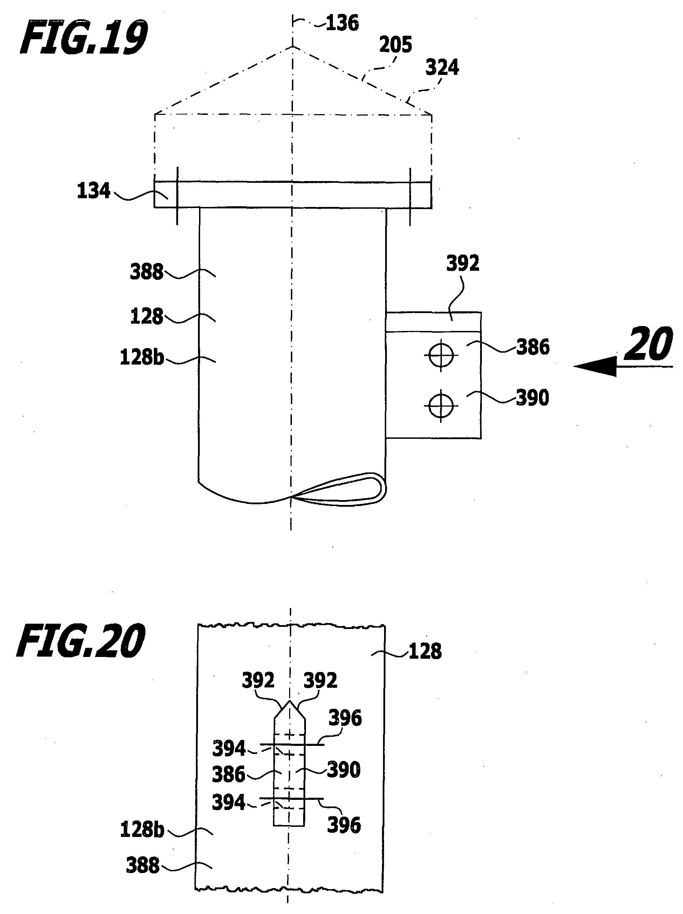

Am freien Ende des horizontalen Schenkel 382 des Haltewinkels 378 ist eine Halterungsaufnahme 384 vorgesehen, welche auf eine Halterung 386 aufschiebbar ist, die von einer äußeren Umfangswand 388 der zweiten oberen Medium-Durchführung 128b radial zur Längsmittelachse 136 der oberen Medium-Durchführung 128b in den Innenraum 112 des Prozessbehälters 100 vorsteht. Diese Halterung 386 ist in den Fig. 19 und 20 im Einzelnen dargestellt.

Die Halterung 386 umfasst einen stoffschlüssig, beispielsweise durch Verschweißung, mit der äußeren Umfangswand 388 der oberen Medium-Durchführung 128 verbundenen, im Wesentlichen quaderförmigen Haltekörper 390, der sich an seinem oberen Ende keilförmig verjüngt, so dass die Halterung 386 nach oben durch zwei gegen die horizontale geneigte Außenflächen 392 begrenzt ist.

Durch die Neigung der Außenflächen 392 gegenüber der Horizontalen wird erreicht, dass sich weder Flüssigkeiten noch Partikel an den Außenflächen 392 ablagern, wenn die Halterung 386 nicht benutzt wird und somit frei zugänglich im Innenraum 112 des Prozessbehälters 100 angeordnet ist.

Ferner weist der Haltekörper 390 eine oder mehrere, vorzugsweise im Wesentlichen horizontal ausgerichtete, Durchgangsbohrungen 394 auf, welche mit jeweils zugeordneten Durchgangsbohrungen in der Halterungsaufnahme 384 des Haltewinkels 378 fluchten, wenn die Halterungsaufnahme 384 auf die Halterung 386 aufgeschoben ist.

Geeignete Befestigungsmittel 396, die in Fig. 20 nur rein schematisch mit ihren Längsachsen als gebrochene Linien dargestellt sind, können dann durch die miteinander fluchtenden Durchgangsbohrungen in der Halterungsaufnahme 384 und im Haltekörper 390 hindurchgeführt und mit geeigneten Arretiermitteln, beispielsweise Befestigungsmuttern, in ihrer Lage an der Halterung 386 und an der Halterungsaufnahme 384 arretiert werden, so dass die Halterungsaufnahme 384 an der Halterung 386 befestigt ist.

Wie in Fig. 19 schematisch dargestellt, kann an der mit der Halterung 386 versehenen oberen Medium-Durchführung 128 statt einer Behandlungseinheit 206 auch ein Verschlussdeckel 324 als Prozesselement 205 adaptiert sein.

Wie insbesondere aus Fig. 3 zu ersehen ist, sind die Halterungen 386 der oberen Medium-Durchführungen 128 vorzugsweise so ausgerichtet, dass sie zur Mittelachse 110 des Prozessbehälters 100 hin weisen.

Das Arretiersystem 370 weist ferner ein bewegliches Spannelement 396 auf, das an einem weiteren Haltewinkel 398 mit einem vertikalen Schenkel 400 und einem horizontalen Schenkel 402 angeordnet ist.

Am freien Ende des horizontalen Schenkels 402 des weiteren Haltewinkels 398 ist eine Halterungsaufnahme 404 angeordnet, welche ebenso ausgebildet ist wie die vorstehend beschriebene Halterungsaufnahme 384 des ersten Haltewinkels 378 und mit einer Halterung 386 an der äußeren Umfangswand 388 der ersten oberen Medium-Durchführung 128a so zusammenwirkt, dass der weitere Haltewinkel 398 mittels der Halterung 386 an der ersten oberen Medium-Durchführung 128a gehalten ist.

Der weitere Haltewinkel 398 trägt ferner eine Antriebsvorrichtung 406, mittels welcher das bewegliche Spannelement 396 von einer in Fig. 18 dargestellten Spannstellung relativ zu dem stationären Spannelement 376 und dem Werkstück 196 in eine (nicht dargestellte) Freigabestellung und von der Freigabestellung in die Spannstellung bewegbar ist.

Elektrische Energie ist zu der Antriebsvorrichtung 406 mittels zweier Energiezuführleitungen 408 zuführbar, welche durch den Innenraum der ersten oberen Medium-Durchführung 128a hindurchgeführt sind.

Die Energiezuführleitungen 408 verlaufen durch eine Führungsplatte 410 hindurch, welche als Prozesselement 205 an den innenraumseitigen Adapter 134 der ersten oberen Medium-Durchführung 128a adaptiert ist.

Das zu behandelnde Werkstück 196 wird mittels des Handhabungsgeräts 192 in die Behandlungsposition im Innenraum 112 des Prozessbehälters 100 gebracht und insbesondere zwischen dem stationären Spannelement 376 und dem in der Freigabestellung befindlichen beweglichen Spannelement 396 angeordnet.

Daraufhin wird die Antriebsvorrichtung 406 von einer (nicht dargestellten) Steuervorrichtung der Behandlungsvorrichtung, welche den Prozessbehälter 100 umfasst, betätigt, um das bewegliche Spannelement 396 von der Freigabestellung in die Spannstellung zu bewegen, in welcher das zu behandelnde Werkstück 196 zwischen das bewegliche Spannelement 396 und das stationäre Spannelement 376 eingespannt und hierdurch in der Behandlungsposition, vorzugsweise formschlüssig, arretiert ist.

Statt durch eine Steuervorrichtung der Behandlungsvorrichtung kann die Antriebsvorrichtung 406 auch durch das Handhabungsgerät 192 betätigt werden, nachdem das Handhabungsgerät 192 das Werkstück 196 in der Behandlungsposition abgesetzt hat.

In diesem Fall weist die Antriebsvorrichtung 406 vorzugsweise ein von dem Handhabungsgerät 192 betätigbares (nicht dargestelltes) Betätigungselement, beispielsweise einen Tastschalter oder einen Nährungssensor, welcher auf die Anwesenheit des Handhabungsgeräts 192 reagiert, auf.

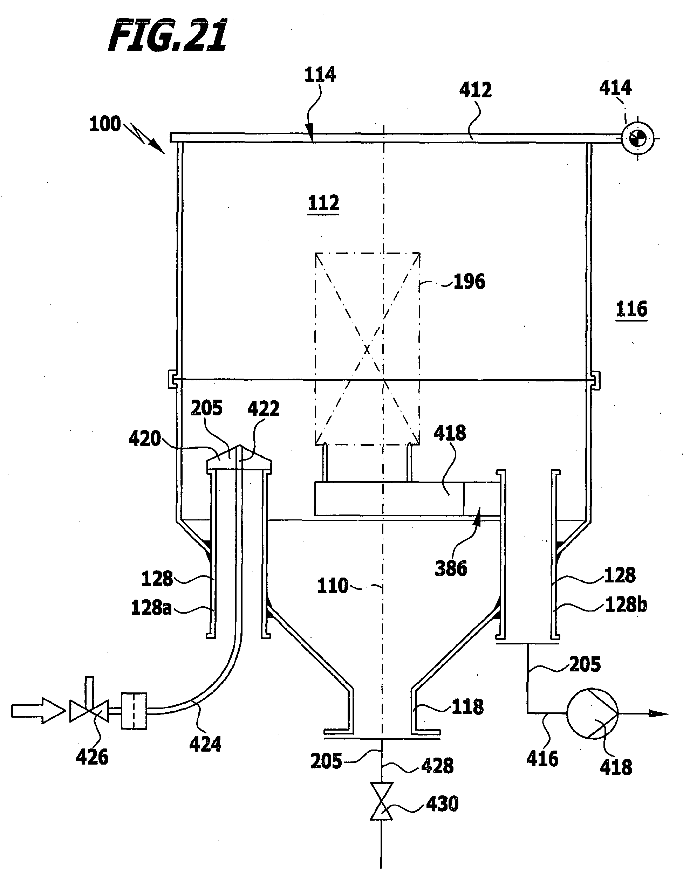

Eine in Fig. 21 dargestellte, nicht erfindungsgemäße Konfiguration des Prozessbehälters 100 dient zur Durchführung einer Vakuumtrocknung an einem Werkstück 196.

Um den Innenraum 112 des Prozessbehälters 100 hierfür fluiddicht verschließen zu können, ist der Prozessbehälter 100 bei dieser Konfiguration mit einem vakuumdichten Deckel 412 versehen, mittels welchem die obere Zugangsöffnung 114 des Prozessbehälters 100 verschließbar ist.

Um das Werkstück 196 mittels des Handhabungsgeräts 192 durch die Zugangsöffnung 114 in den Innenraum 112 des Prozessbehälters 100 einbringen zu können, ist der Deckel 412 um eine, vorzugsweise im Wesentlichen horizontale, Schwenkachse 414 schwenkbar gelagert.

Um den Innenraum 112 des Prozessbehälters 100 evakuieren zu können, ist an die zweite obere Medium-Durchführung 128b bei dieser Konfiguration des Prozessbehälters 100 außenraumseitig als Prozesselement 205 eine Ansaugleitung 416 einer Vakuumpumpe 418 adaptiert.

An der Halterung 386 der zweiten oberen Medium-Durchführung 128b im Innenraum 112 des Prozessbehälters 100 ist eine Werkstückaufnahme 418, insbesondere in Form einer Werkstückauflage, gehalten.

Das Werkstück 196, das vakuumgetrocknet werden soll, kann mittels des Handhabungsgeräts 192 in den Innenraum 112 des Prozessbehälters 100 eingebracht und an der Werkstückaufnahme 418 abgesetzt werden.

An die erste obere Medium-Durchführung 128a ist in dieser Konfiguration innenraumseitig als Prozesselement 205 und Behandlungseinheit 206 eine Belüftungseinheit 420 adaptiert.

Die Belüftungseinheit 420 ist ähnlich aufgebaut wie ein Verschlussdeckel 324 zum Verschließen des Innenraums der oberen Medium-Durchführung 128 gegenüber dem Innenraum 112 des Prozessbehälters 100, ist jedoch mit einem Belüftungskanal 422 versehen, welcher die Belüftungseinheit 420 durchsetzt und an eine Belüftungsleitung 424 angeschlossen ist, welche sich durch den Innenraum der ersten oberen Medium-Durchführung 128a hindurch erstreckt und zu einem Belüftungsventil 426 führt.

Durch Öffnen des Belüftungsventils 426 kann der Innenraum 112 des Prozessbehälters 100, beispielsweise mit Umgebungsluft, belüftet werden, bevor der Deckel 412 geöffnet wird, um das Werkstück 196 nach Abschluss der Vakuumtrocknung aus dem Innenraum 112 des Prozessbehälters 100 zu entnehmen.

An die untere Medium-Durchführung 118 ist bei dieser Konfiguration außenraumseitig als Prozesselement 205 eine Kondensat-Ablassleitung 428 mit einem darin angeordneten Kondensat-Ablassventil 430 adaptiert.

Durch Öffnen des Kondensat-Ablassventils 430 kann Kondensat, das sich am Boden des Innenraums 112 des Prozessbehälters 100 angesammelt hat, aus dem Innenraum 112 angelassen werden, wenn der Innenraum 112 über die Belüftungsleitung 424 belüftet worden ist.

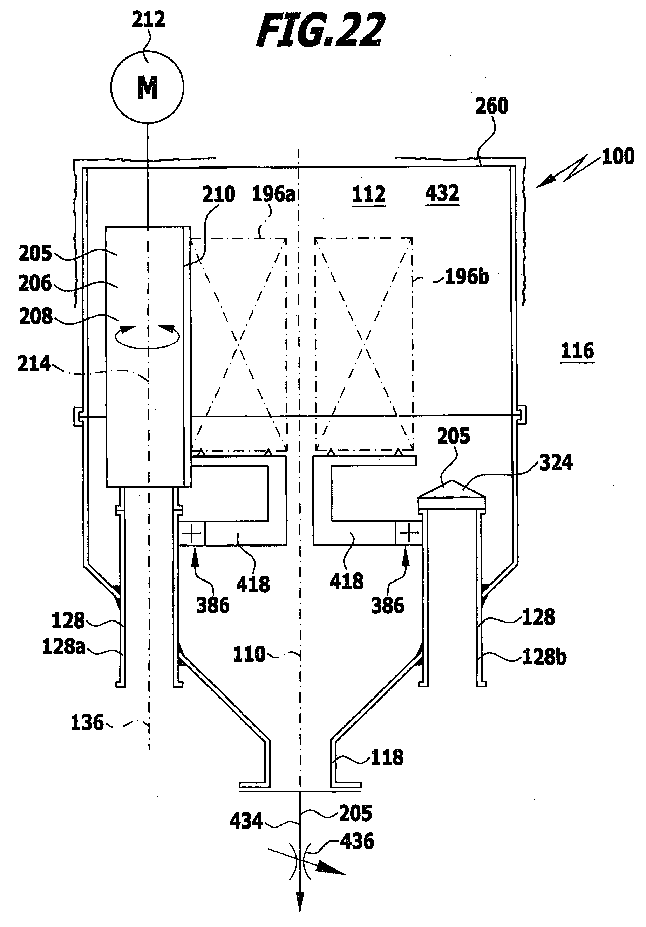

Eine in Fig. 22 dargestellte alternative Konfiguration des Prozessbehälters 100 dient zum gleichzeitigen Durchführen eines Injektionsflutwaschvorgangs an mehreren Werkstücken 196, die gleichzeitig im Innenraum 112 des Prozessbehälters 100 angeordnet sind.

Hierfür ist, wie bei der in Fig. 7 dargestellten Konfiguration des Prozessbehälters 100, an die erste obere Medium-Durchführung 128a innenraumseitig als Prozesselement 205 und Behandlungseinheit 206 ein bewegliches Düsensystem 208 adaptiert, welches eine Spaltdüse 210 aufweist, die zur Erzeugung eines Reinigungsmediumsstrahls dient.

Die Spaltdüse 210 ist mittels eines motorischen Drehantriebs 212 um eine, vorzugsweise vertikal ausgerichtete, Drehachse 214, welche mit der Längsmittelachse 136 der oberen Medium-Durchführung 128 zusammenfallen kann, drehbar.

An der Halterung 386 der ersten oberen Medium-Durchführung 128a ist eine Werkstückaufnahme 418 gehalten, an welcher das erste Werkstück 196a für einen Reinigungsvorgang von dem Handhabungsgerät 192 absetzbar ist.

An der Halterung 386 der zweiten oberen Medium-Durchführung 128b ist eine weitere Werkstückaufnahme 418 gehalten, an welcher ein zweites zu behandelndes Werkstück 196b von dem Handhabungsgerät 192 absetzbar ist.

Der Innenraum 112 des Prozessbehälters 100 ist bis zu dessen oberem Rand 260 mit einem Reinigungsmedium-Bad 432 gefüllt.

Der obere Rand 260 des Prozessbehälters 100 dient als Überlauf, über den überschüssiges Reinigungsmedium (zusammen mit leichten Schmutzpartikeln und gegebenenfalls Ölen, welche eine geringere Dichte als das Reinigungsmedium aufweisen) aus dem Innenraum 112 des Prozessbehälters 100 abläuft, wenn mittels der Spaltdüse 210 zusätzliches Reinigungsmedium in den Innenraum 112 des Prozessbehälters zugeführt wird.

Durch das Drehen der Spaltdüse 210 um die Drehachse 214 können beide Werkstücke 196a und 196b abwechselnd mit einem Strahl des Reinigungsmediums innerhalb des Reinigungsmedium-Bades 432 beaufschlagt werden.

Es ist auch denkbar, die Behandlungspositionen der beiden Werkstücke 196a und 196b nach einer gewissen Reinigungszeit mittels des Handhabungsgeräts 192 zu vertauschen oder eines der Werkstücke 196a und 196b ganz aus dem Innenraum 112 zu entnehmen und das jeweils andere Werkstück 196b bzw. 196a mittels des Handhabungsgeräts 192 an die Behandlungsposition des aus dem Innenraum 112 entfernten Werkstücks 196a bzw. 196b zu bringen.

Die zweite obere Medium-Durchführung 128b und gegebenenfalls auch die (in Fig. 22 nicht dargestellte) dritte obere Medium-Durchführung 128c sind in dieser Konfiguration vorzugsweise mittels eines Verschlussdeckels 324 als Prozesselement 205 verschlossen.

Zum Entleeren des Prozessbehälters 100 dient eine Reinigungsmedium-Abführleitung 434, welche außenraumseitig als Prozesselement 205 an die untere Medium-Durchführung 118 adaptiert ist und mittels eines Sperrventils 436 verschließbar ist.

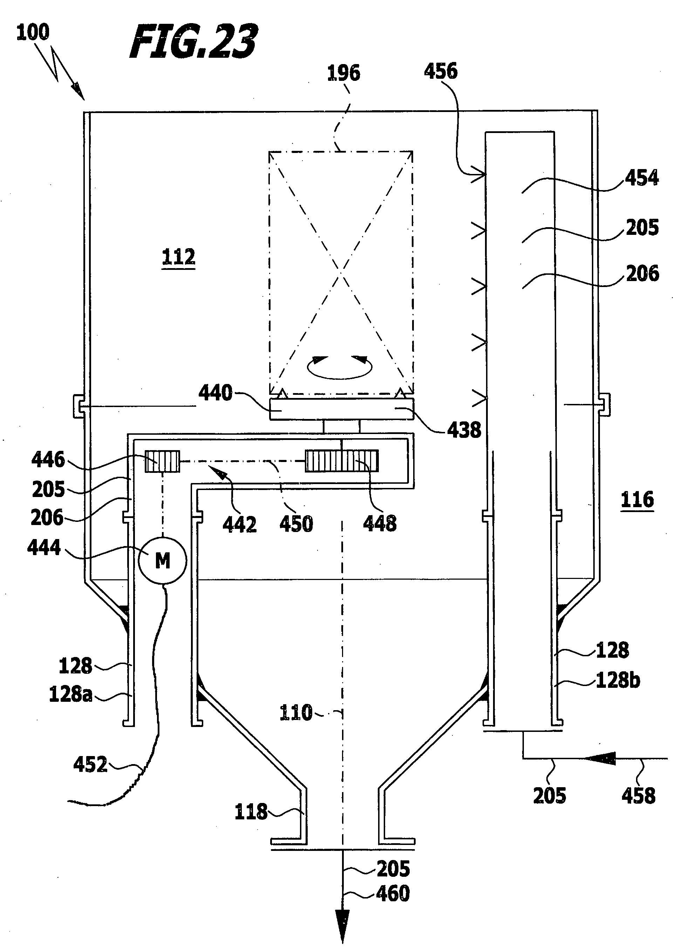

Eine in Fig. 23 dargestellte alternative Konfiguration des Prozessbehälters 100 dient zur Durchführung einer Spritzreinigung an einem Werkstück 196, das mittels einer Dreheinrichtung 438 während des Abspritzvorgangs gedreht wird. Hierfür ist an die erste obere Medium-Durchführung 128a innenraumseitig als Prozesselement 205 und Behandlungseinheit 206 die Werkstückdreheinrichtung 438 adaptiert.

Die Werkstückdreheinrichtung 438 umfasst eine drehbare Werkstückaufnahme 440, an welcher das Werkstück 196 mittels des Handhabungsgeräts 196 absetzbar ist, und eine Drehantriebsvorrichtung 442, welche einen Antriebsmotor 444 zum Antreiben eines ersten Ritzels 446, ein drehfest mit der drehbaren Werkstückaufnahme 440 verbundenes zweites Ritzel 448 und einen Kopplungsriemen 450 zum Koppeln des ersten Ritzels 446 und des zweiten Ritzels 448 umfassen kann.

Die Zufuhr von Energie zu dem Antriebsmotor 444 erfolgt über eine Energiezuführleitung 452, welche sich durch den Innenraum der ersten oberen Medium-Durchführung 128a hindurch erstreckt.

An die zweite obere Medium-Durchführung 128b ist bei dieser Konfiguration des Prozessbehälters 100 innenraumseitig als Prozesselement 205 und Behandlungseinheit 206 ein Spritzdüsensystem 454 adaptiert.

Das Spritzdüsensystem 454 weist mehrere Spritzdüsen 456 auf, mittels welcher jeweils ein gegen das Werkstück 196 gerichteter Spritzstrahl eines flüssigen Reinigungsmediums erzeugbar ist.

Die Spritzdüsen 456 sind in einer Längsrichtung des Spritzdüsensystems 454 aufeinanderfolgend angeordnet.

Außenraumseitig ist die zweite obere Medium-Durchführung 128b an eine Reinigungsmedium-Zuführleitung 458 als Prozesselement 205 angeschlossen.

Die (in Fig. 23 nicht dargestellte) dritte obere Medium-Durchführung 128c kann bei dieser Konfiguration ebenfalls mit einem Spritzdüsensystem 454 versehen oder aber mittels eines Verschlussdeckels 324 verschlossen sein.

An die untere Medium-Durchführung 118 ist bei dieser Konfiguration des Prozessbehälters 100 außenraumseitig als Prozesselement 205 eine Reinigungsmittel-Abführleitung 460 adaptiert.

Die Werkstückdreheinrichtung 438 kann auch mit anderen Behandlungseinheiten 206, beispielsweise zur Durchführung eines Injektionsflutwaschvorgangs, eines Abblasvorgangs, eines Ultraschallreinigungsvorgangs oder eines Entgratungsvorgangs, kombiniert werden.

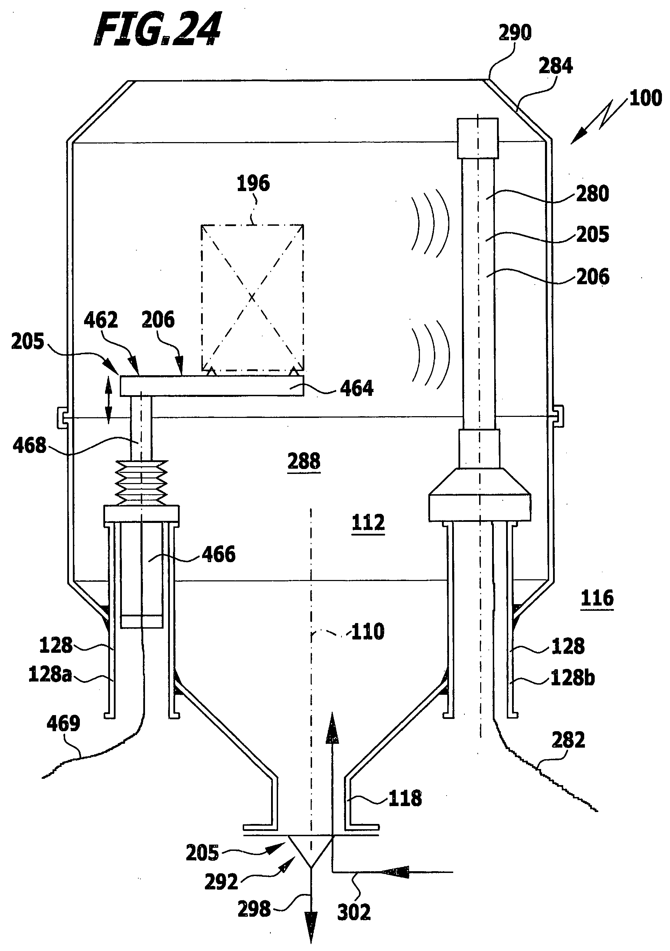

Eine in Fig. 24 dargestellte alternative Konfiguration des Prozessbehälters 100 dient zur Durchführung einer Ultraschallreinigung an einem Werkstück 196, das mittels einer Werkstückhubeinrichtung 462 im Innenraum 112 des Prozessbehälters 100 relativ zu einem Ultraschallschwinger 280 bewegbar ist.

Hierfür ist an die erste obere Medium-Durchführung 128a innenraumseitig als Prozesselement 205 und Behandlungseinheit 206 die Werkstückhubeinrichtung 462 adaptiert.

Die Werkstückhubeinrichtung 462 umfasst eine bewegliche Werkstückaufnahme 462, an welcher mittels des Handhabungsgeräts 192 das Werkstück 196 abgesetzt werden kann.

Ferner umfasst die Werkstückhubeinrichtung 462 eine Bewegungseinrichtung 466, mittels welcher eine Hubstange 468, die die Werkstückaufnahme 464 trägt, in der vertikalen Längsrichtung der Hubstange 468 auf und ab bewegt werden kann.

Wie auch bei der in den Fig. 10 und 11 dargestellten Konfiguration des Prozessbehälters 100 ist der Innenraum 112 des Prozessbehälters 100 bis zum oberen Rand 290 eines auf das Behälteroberteil 104 aufgesetzten Reflektionsschirms 284 mit einem Reinigungsmedium-Bad 288 gefüllt, welches der Übertragung von Ultraschallwellen von dem Ultraschallschwinger 280 zu dem Werkstück 196 dient.

Der Ultraschallschwinger 280 ist als Prozesselement 205 und Behandlungseinheit 206 innenraumseitig an die zweite obere Medium-Durchführung 128b adaptiert.

Eine Energiezuführleitung 282 des Ultraschallschwingers 280 erstreckt sich durch den Innenraum der zweiten oberen Medium-Durchführung 128b hindurch in den Außenraum 116 des Prozessbehälters 100.

Eine Energiezuführleitung 486, welche zum Zuführen der erforderlichen elektrischen Energie zur Bewegungseinrichtung 466 der Werkstückhubeinrichtung 462 dient, erstreckt sich durch den Innenraum der ersten oberen Medium-Durchführung 128a hindurch in den Außenraum 116 des Prozessbehälters 100.

An die untere Medium-Durchführung 118 ist bei dieser Konfiguration des Prozessbehälters 100, wie auch bei der in den Fig. 10 und 11 dargestellten Konfiguration, ein kombinierter Ab- und Zulaufanschluss 292 adaptiert, um Reinigungsmedium in den Innenraum 112 des Prozessbehälters 100 zuführen und überschüssiges Reinigungsmedium sowie Schmutzpartikel aus dem Innenraum 112 des Prozessbehälters 100 abführen zu können.

Mittels der Werkstückhubeinrichtung 462 kann bei der in Fig. 24 dargestellten Konfiguration des Prozessbehälters 100 das an der Werkstückhubeinrichtung 462 abgesetzte Werkstück 196 während der Ultraschallreinigung relativ zu dem Ultraschallschwinger 280 linear bewegt werden, insbesondere auf und ab bewegt werden, um verschiedene Stellen der Oberfläche des Werkstücks 196 nacheinander mit Ultraschall von unterschiedlicher Intensität zu beaufschlagen.

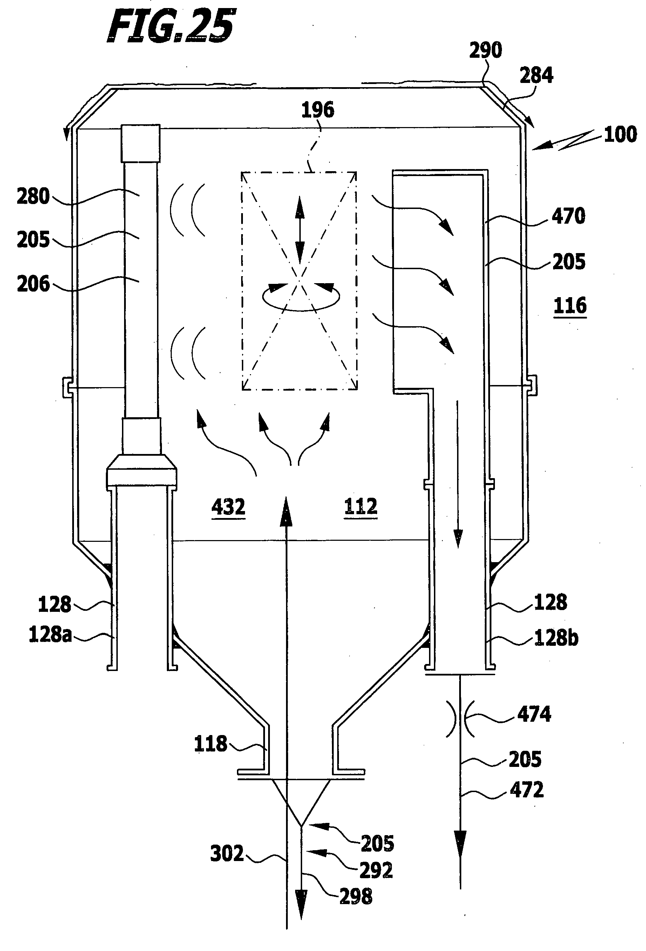

Eine in Fig. 25 dargestellte alternative Konfiguration des Prozessbehälters 100 dient zur Durchführung einer Ultraschallreinigung an einem Werkstück 196, das im Innenraum 112 des Prozessbehälters 100 angeordnet ist, wobei vom Werkstück 196 durch die Ultraschallreinigung gelöste Verunreinigungen gezielt abgesaugt werden.

Hierfür ist an die erste obere Medium-Durchführung 128a als Prozesselement 205 und Behandlungseinheit 206 innenraumseitig ein Ultraschallschwinger 280 adaptiert.

An die zweite obere Medium-Durchführung 128b ist innenraumseitig als Prozesselement 205 und Behandlungseinheit 206 eine Absaughaube 470 und außenraumseitig als Prozesselement 205 eine Absaugleitung 472 adaptiert.

In der Absaugleitung 472 kann, wie in Fig. 25 dargestellt, eine Venturidüse 474 oder eine Ablaufdrossel angeordnet sein.

Alternativ oder ergänzend hierzu kann in der Absaugleitung 472 eine Saugpumpe angeordnet sein.

Ferner ist es möglich, dass die Absaugleitung 472 einen freien Auslauf bildet, in welchem die in die Absaughaube 470 eintretende Flüssigkeit allein aufgrund der Wirkung der Schwerkraft nach unten aus dem Innenraum 112 des Prozessbehälters 100 herausströmt.

An die untere Medium-Durchführung 118 ist bei dieser Konfiguration, ebenso wie bei den Konfigurationen aus den Fig. 10 und 24, ein kombinierter Ab- und Zulaufanschluss 292 adaptiert.

Auf das Behälteroberteil 104 des Prozessbehälters 100 ist ein Reflektionsschirm 284 aufgesetzt, dessen oberer Rand 290 einen Überlauf bildet, über welchen überschüssiges Reinigungsmedium aus dem Innenraum 112 des Prozessbehälters 100 ablaufen kann.

Bei der in Fig. 25 dargestellten Konfiguration des Prozessbehälters 100 werden mittels des von dem Ultraschallerzeuger 280 erzeugten Ultraschalls von dem Werkstück 196 abgelöste Verunreinigungen durch die Absaughaube 470, welche vorzugsweise auf der dem Ultraschallschwinger 280 abgewandten Seite des Werkstücks 196 angeordnet ist, aus dem Innenraum 112 des Prozessbehälters 100, der mit einem Reinigungsmedium-Bad 432 gefüllt ist, abgesaugt, so dass eine Verunreinigung des Reinigungsmedium-Bades 432 und eine hierdurch hervorgerufene Rückverschmutzung des Werkstücks 196 vermieden wird.

Das Werkstück 196 kann während der Ultraschallreinigung mittels des Handhabungsgeräts 192 im Innenraum 112 des Prozessbehälters 100 gehalten sein und optional mittels des Handhabungsgeräts 192 relativ zu dem Ultraschallschwinger 280 bewegt werden, beispielsweise gedreht und/oder auf und ab bewegt werden.

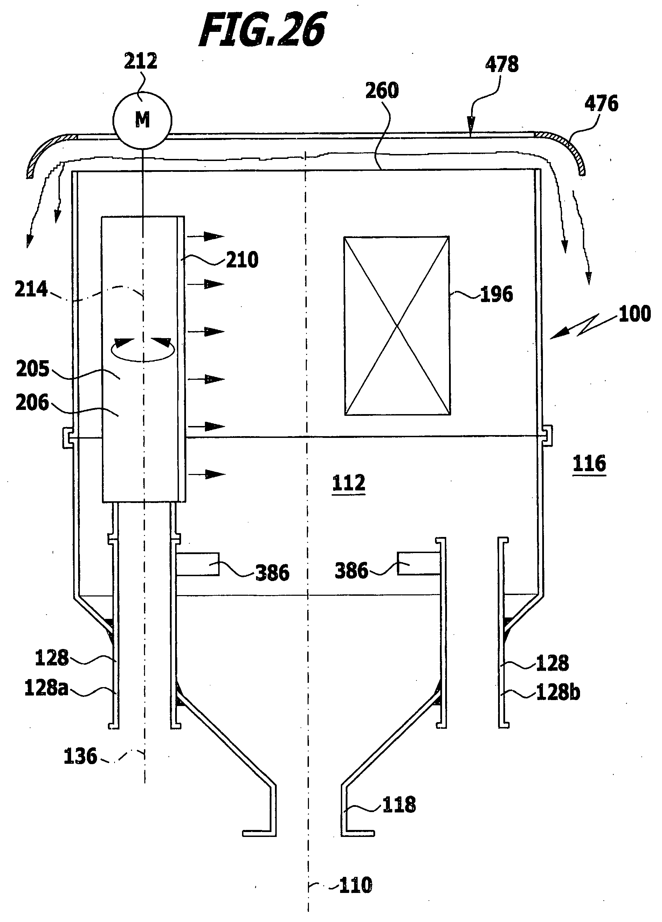

Eine in Fig. 26 dargestellte alternative Konfiguration des Prozessbehälters 100 dient zur Durchführung einer Spritzreinigung an einem Werkstück 196, das im Innenraum 112 des Prozessbehälters 100 angeordnet ist, wobei ein Austreten von Fluid (beispielsweise ein wässriges Reinigungsmittel, ein Öl, ein Kühlschmierstoff, ein Kohlenwasserstoff und so weiter) in einen Bereich oberhalb des Prozessbehälters 100 durch ein Leitblech 476 vermieden wird.

Hierfür ist an die erste obere Medium-Durchführung 128a als Prozesselement 205 und Behandlungseinheit 206 innenraumseitig ein bewegliches Düsensystem 208 adaptiert.

Das bewegliche Düsensystem 208 umfasst eine Spaltdüse 210, die mittels eines motorischen, pneumatischen oder hydraulischen Drehantriebs 212 um eine, vorzugsweise mit der Längsmittelachse 136 der oberen Medium-Durchführung 128a zusammenfallende, Drehachse 214 drehbar ist.

Mittels der Spaltdüse 210 ist ein auf das Werkstück 196 gerichteter Reinigungsmediumstrahl im mit einem Bad des Reinigungsmediums gefüllten Prozessbehälter 100 erzeugbar.

Am oberen Rand 260 des Prozessbehälters 100 überlaufendes Reinigungsmedium, gegebenenfalls mit darin enthaltenen Verunreinigungen, wird von dem Leitblech 476 in den Innenraum 112 des Prozessbehälters 100 zurück oder nach unten gegen die Außenwand des Prozessbehälters 100 reflektiert, so dass dieses Reinigungsmedium nicht in den Bereich oberhalb des Leitblechs 476 gelangt.

Das Leitblech 476 ist ringförmig ausgebildet und weist, vom Innenraum 112 des Prozessbehälters 100 aus gesehen, eine konkave Krümmung auf.

Das Leitbleich 476 umgibt eine mittige Durchtrittsöffnung 478, durch welche das Werkstück 196 mittels des Handhabungsgeräts 192 in den Innenraum 112 des Prozessbehälters 100 einbringbar ist.

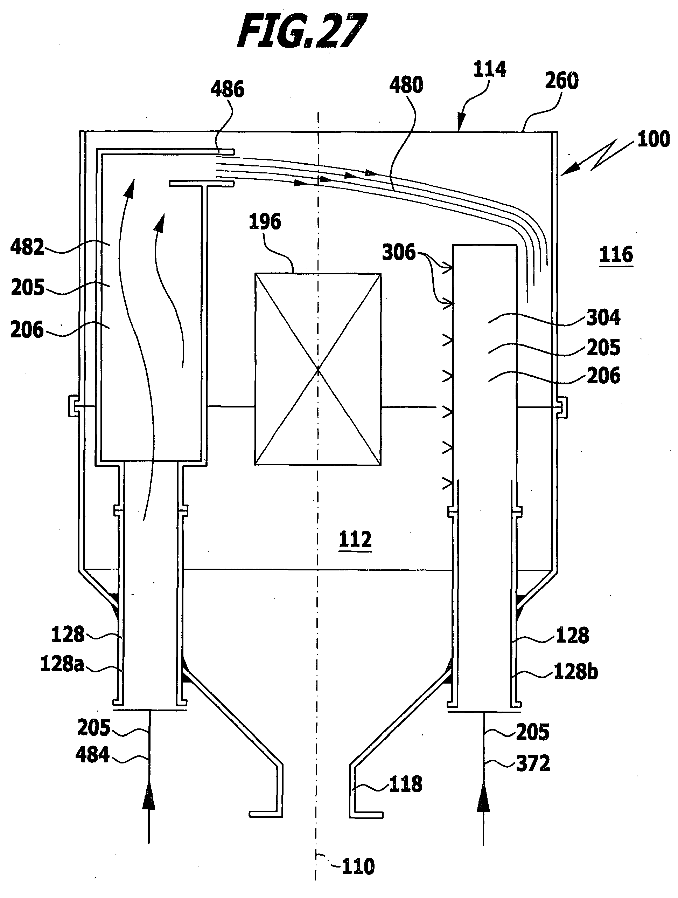

Eine in Fig. 27 dargestellte alternative Konfiguration des Prozessbehälters 100 dient zur Durchführung einer Spritzreinigung an einem Werkstück 196, welches im Innenraum 112 des Prozessbehälters 100 angeordnet ist, wobei ein Flüssigkeitsvorhang 480 erzeugt wird, welcher verhindert, dass Reinigungsmedium-Overspray aus dem Innenraum 112 des Prozessbehälters 100 durch die Zugangsöffnung 114 nach außen gelangt.

Hierfür ist an die zweite obere Medium-Durchführung 128b als Prozesselement 205 und Behandlungseinheit 206 innenraumseitig ein Spritzdüsensystem 304 mit mehreren Spritzdüsen 306 adaptiert.

Außenraumseitig ist an die zweite obere Medium-Durchführung 128b als Prozesselement 205 eine Prozessfluid-Zuführleitung 372 adaptiert.

Mittels der Spritzdüsen 306 des Spritzdüsensystems 304 sind aus dem Prozessfluid gegen das Werkstück 196 gerichtete Prozessfluid-Strahlen erzeugbar.

An die erste obere Medium-Durchführung 128a ist bei dieser Konfiguration des Prozessbehälters 100 innenraumseitig als Prozesselement 205 und Behandlungseinheit 206 ein Flüssigkeitsvorhangerzeuger 482 adaptiert.

Außenraumseitig ist an die erste obere Medium-Durchführung 128a als Prozesselement 205 eine Flüssigkeitszuführleitung 484 adaptiert.

Der Flüssigkeitsvorhangerzeuger 482 umfasst eine Spaltdüse 486 an seinem oberen Ende, mittels welcher aus der zugeführten Flüssigkeit ein Flüssigkeitsvorhang 480 erzeugbar ist, der sich von der Spaltdüse 486 über das in der Behandlungsposition befindliche Werkstück 196 und über das Spritzdüsensystem 304 hinweg erstreckt, so dass das Werkstück 196 durch den Flüssigkeitsvorhang 480 von der Zugangsöffnung 114 am oberen Rand 260 des Prozessbehälters 100 getrennt ist.

Durch Zerstäubung der Prozessfluid-Strahlen an der Oberfläche des Werkstücks 196 entstehender Prozessfluid-Overspray wird durch den Flüssigkeitsvorhang 480 im Innenraum 112 des Prozessbehälters 100 zurückgehalten und gelangt somit nicht in den Außenraum 116 des Prozessbehälters 100.

Vielmehr läuft das gesamte überschüssige Prozessfluid, zusammen mit der für den Flüssigkeitsvorhang 480 verwendeten Flüssigkeit, durch die untere Medium-Durchführung 118 aus dem Innenraum 112 des Prozessbehälters 100 ab.

## Patentansprüche

1. Prozessbehälter zum Durchführen eines Reinigungsvorgangs, eines Trocknungsvorgangs, eines Entgratungsvorgangs, eines Beschichtungsvorgangs und/oder eines Entschichtungsvorgangs an einem Werkstück (196) im Innenraum (112) des Prozessbehälters (100), umfassend eine den Innenraum (112) des Prozessbehälters (100) begrenzende Wandung (124),
wobei der Prozessbehälter (100) mindestens eine Medium-Durchführung (118, 128) umfasst, mittels welcher ein Medium durch die Wandung (124) des Prozessbehälters (100) hindurchführbar ist,
wobei an mindestens eine der Medium-Durchführungen (118, 128) mindestens zwei verschiedene Prozesselemente unterschiedlichen Typs adaptierbar sind,
wobei der Prozessbehälter (100) ein Behälterunterteil (102) und ein auf das Behälterunterteil (102) abnehmbar aufgesetztes Behälteroberteil (104) umfasst und
wobei die mindestens eine Medium-Durchführung (118, 120) sich durch die Wandung (124) des Behälterunterteils (102) hindurch erstreckt,
**dadurch gekennzeichnet,**
**dass** der Prozessbehälter (100) eine am oberen Rand (260) des Behälteroberteils (104) und an einer Oberseite des Prozessbehälters (100) angeordnete unverschlossene Zugangsöffnung (114) aufweist, über welche ein von dem Behälterunterteil (102) und dem Behälteroberteil (104) umschlossener Innenraum (112) des Prozessbehälters (100) von einem Außenraum (116) des Prozessbehälters (100) aus zugänglich ist und durch welche ein an einem Handhabungsgerät (192) gehaltenes Werkstück (196) für einen Behandlungsvorgang in den Innenraum (112) des Prozessbehälters (100) einbringbar und nach abgeschlossener Behandlung aus dem Prozessbehälter (100) entnehmbar ist.

2. Prozessbehälter nach Anspruch 1, **dadurch gekennzeichnet, dass** mindestens eine der Medien-Durchführungen (118, 128) einen totraumfreien Adapter (126, 132, 134) zum Adaptieren eines Prozesselements aufweist.

3. Prozessbehälter nach einem der Ansprüche 1 oder 2, **dadurch gekennzeichnet, dass** der Prozessbehälter (100) mindestens zwei Medium-Durchführungen (128) umfasst, die miteinander identische Adapter (132, 134) aufweisen.

4. Prozessbehälter nach einem der Ansprüche 1 bis 3, **dadurch gekennzeichnet, dass** der Prozessbehälter (100) zwei oder mehr Medien-Durchführungen (118, 128) umfasst.

5. Prozessbehälter nach Anspruch 4, **dadurch gekennzeichnet, dass** mindestens zwei der Medium-Durchführungen (128) in im Wesentlichen konstanten Winkelabständen bezüglich einer vertikalen Mittelachse (110) des Prozessbehälters (100) angeordnet sind.

6. Prozessbehälter nach einem der Ansprüche 1 bis 5, **dadurch gekennzeichnet, dass** eine der Medien-Durchführungen (118) an einer tiefsten Stelle des Innenraums (112) des Prozessbehälters (100) in den Innenraum (112) des Prozessbehälters (100) mündet.

7. Prozessbehälter nach einem der Ansprüche 1 bis 6, **dadurch gekennzeichnet, dass** das Behälteroberteil (104) mittels einer totraumfreien Dichtungsanordnung (144) mit einem Behälterunterteil (102) des Prozessbehälters (100) verbunden ist.

8. Prozessbehälter nach einem der Ansprüche 1 bis 7, **dadurch gekennzeichnet, dass** die Wandung (124) des Prozessbehälters (100) zumindest an deren Innenseite zumindest abschnittsweise eine Oberflächenrauigkeit von weniger als ungefähr 0,8 µm aufweist.

9. Prozessbehälter nach einem der Ansprüche 1 bis 8, **dadurch gekennzeichnet, dass** mindestens eine der Medium-Durchführungen (128) mittels eines an einen Adapter (134) der Medium-Durchführung (128) adaptierten Verschlussdeckels (324) verschließbar ist.

10. Prozessbehälter nach einem der Ansprüche 1 bis 9, **dadurch gekennzeichnet, dass** der Prozessbehälter (100) ein Aufnahmeelement (182) umfasst, über welches der Prozessbehälter (100) an einer externen Lagerung (184) abstützbar ist.

11. Prozessbehälter nach Anspruch 10, **dadurch gekennzeichnet, dass** mindestens eine der Medien-Durchführungen (128) einen außerhalb des Innenraums (112) des Prozessbehälters (100) angeordneten Adapter (132) zum Adaptieren des Aufnahmeelements (182) an die Medium-Durchführung (128) aufweist.

12. Kombination aus mindestens einem Prozessbehälter (100) nach einem der Ansprüche 1 bis 11 und mindestens zwei Prozesselementen unterschiedlichen Typs, die wahlweise an dieselbe Medium-Durchführung (118, 128) des Prozessbehälters (100) adaptierbar sind.

13. Kombination aus mindestens zwei Prozessbehältern (100) nach einem der Ansprüche 1 bis 11 und mindestens einem Prozesselement, das wahlweise an eine Medium-Durchführung (118, 128) eines ersten Prozessbehälters (100) oder an eine Medium-Durchführung (118, 128) eines zweiten Prozessbehälters (100) adaptierbar ist.

14. Kombination nach einem der Ansprüche 12 oder 13, **dadurch gekennzeichnet, dass** die Kombination ferner mindestens ein Handhabungsgerät (192) zum Einbringen eines zu behandelnden Werkstücks (196) in den Innenraum (112) mindestens eines der Prozessbehälter (100) umfasst.

15. Kombination nach einem der Ansprüche 12 bis 14, **dadurch gekennzeichnet, dass** die Kombination als Prozesselement eine Spritzreinigungseinheit, eine Injektions-Flutwascheinheit, eine Ultraschallreinigungseinheit, eine Hochdruckentgratungseinheit, eine Burstentgratungseinheit, eine Blastrocknungseinheit, eine Dampfreinigungseinheit, eine Absaugeinheit, eine Belüftungseinheit, eine Werkstückaufnahme, eine Werkstückbewegungseinheit und/oder eine Flüssigvorhangerzeugungseinheit umfasst.

## Claims

1. Process container for carrying out a cleaning process, a drying process, a deburring process, a coating process and/or a coating removal process on a workpiece (196) in the interior (112) of the process container (100), comprising a wall (124) delimiting the interior (112) of the process container (100),
wherein the process container (100) comprises at least one medium passage (118, 128), by means of which a medium is guidable through the wall (124) of the process container (100), at least two different process elements of different types being adaptable to at least one of the medium passages (118, 128),
wherein the process container (100) comprises a container lower part (102) and a container upper part (104) placed removably on the container lower part (102) and
wherein the at least one medium passage (118, 120) extends through the wall (124) of the container lower part (102),
**characterised in that**
the process container (100) has an open access opening (114) arranged at the upper edge (260) of the container upper part (104) and at an upper side of the process container (100), by means of which an interior (112) enclosed by the container lower part (102) and the container upper part (104) is accessible from an exterior (116) of the process container, and through which a workpiece (196) held on a handling apparatus (192) is introducible into the interior (112) of the process container (100) for a treatment procedure and, after a completed treatment, removable from the process container (100).

2. Process container according to claim 1, **characterised in that** at least one of the media passages (118, 128) has a dead space-free adapter (126, 132, 134) to adapt a process element.

3. Process container according to either of claims 1 or 2, **characterised in that** the process container (100) comprises at least two medium passages (128), which have adapters (132, 134) that are identical to one another.

4. Process container according to any one of claims 1 to 3, **characterised in that** the process container (100) comprises two or more media passages (118, 128).

5. Process container according to claim 4, **characterised in that** at least two of the medium passages (128) are arranged at substantially constant angular spacings with respect to a vertical centre axis (110) of the process container (100).

6. Process container according to any one of claims 1 to 5, **characterised in that** one of the media passages (118) opens into the interior (112) of the process container (100) at a lowest point of the interior (112) of the process container (100).

7. Process container according to any one of claims 1 to 6, **characterised in that** the container upper part (104) is connected to a container lower part (102) of the process container (100) by means of a dead space-free sealing arrangement (144).

8. Process container according to any one of claims 1 to 7, **characterised in that** the wall (124) of the process container (100), at least on its inside, at least in portions, has a surface roughness of less than approximately 0.8 µm.

9. Process container according to any one of claims 1 to 8, **characterised in that** at least one of the medium passages (128) is closable by means of a closure lid (324) adapted to an adapter (134) of the medium passage (128).

10. Process container according to any one of claims 1 to 9, **characterised in that** the process container (100) comprises a receiving element (182), by means of which the process container (100) is supportable on an external bearing arrangement (184).

11. Process container according to claim 10, **characterised in that** at least one of the media passages (128) has an adapter (132) arranged outside the interior (112) of the process container (100) to adapt the receiving element (182) to the medium passage (128).

12. Combination of at least one process container (100) according to any one of claims 1 to 11 and at least two process elements of different types, which are selectively adaptable to the same medium passage (118, 128) of the process container (100).

13. Combination of at least two process containers (100) according to any one of claims 1 to 11 and at least one process element, which is selectively adaptable to a medium passage (118, 128) of a first process container (100) or to a medium passage (118, 128) of a second process container (100).

14. Combination according to either of claims 12 or 13, **characterised in that** the combination furthermore comprises at least one handling apparatus (192) for introducing a workpiece (196) to be treated into the interior (112) of at least one of the process containers (100).

15. Combination according to any one of claims 12 to 14, **characterised in that** the combination comprises, as a process element, a spray-cleaning unit, an injection flood washing unit, an ultrasonic cleaning unit, a high pressure deburring unit, a brush deburring unit, a blow drying unit, a steam cleaning unit, a suction unit, a ventilation unit, a workpiece receiver, a workpiece movement unit and/or a liquid curtain generating unit.

## Revendications

1. Conteneur de traitement servant à mettre en oeuvre une opération de nettoyage, une opération de séchage, une opération d'ébavurage, une opération de revêtement et/ou une opération de décapage, au niveau d'une pièce à usiner (196) dans un espace intérieur (112) du conteneur de traitement (100), comprenant une paroi (124) délimitant l'espace intérieur (112) du conteneur de traitement (100),
le conteneur de traitement (100) comprenant au moins un passage de milieu (118, 128), au moyen duquel un milieu peut être guidé à travers la paroi (124) du conteneur de traitement (100),
au moins deux éléments de traitement différents de type différent pouvant être adaptés au niveau au moins d'un des passages de milieu (118, 128),
le conteneur de traitement (100) comprenant une partie inférieure de conteneur (102) et une partie supérieure de conteneur (104) posée de manière à pouvoir être retirée sur la partie inférieure de conteneur (102), et
l'au moins un passage de milieu (118, 120) s'étendant à travers la paroi (124) de la partie inférieure de conteneur (102),
**caractérisé en ce**
**que** le conteneur de traitement (100) présente une ouver-ture d'accès (114) non fermée disposée au niveau du bord supérieur (260) de la partie supérieure de conteneur (104) et au niveau du côté supérieur du conteneur de traitement (100), par l'intermédiaire de laquelle un espace intérieur (112) du conteneur de traitement (100) entouré par la partie inférieure de conteneur (102) et par la partie supérieure de conteneur (104) est accessible depuis un espace extérieur (116) du conteneur de traitement (100) et par laquelle une pièce à usiner (196) maintenue au niveau d'un appareil de manipulation (192) peut être introduite dans l'espace inté-rieur (112) du conteneur de traitement (100) en vue d'une opération d'usinage et peut être retirée du conteneur de traitement (100) une fois l'usinage effectué.

2. Conteneur de traitement selon la revendication 1, caracté-risé en ce qu'au moins un des passages de milieux (118, 128) présente un adaptateur (126, 132, 134) sans espace mort servant à adapter un élément de traitement.

3. Conteneur de traitement selon l'une quelconque des revendications 1 ou 2, **caractérisé en ce que** le conteneur de traitement (100) comprend au moins deux passages de milieu (128), qui présentent des adaptateurs (132, 134) identiques entre eux.

4. Conteneur de traitement selon l'une quelconque des revendications 1 à 3, **caractérisé en ce que** le conteneur de traitement (100) comprend deux passages de milieu (118, 128) ou plus.

5. Conteneur de traitement selon la revendication 4, caracté-risé en ce qu'au moins deux des passages de milieu (128) sont disposés selon des distances angulaires essentiellement constantes par rapport à un axe médian (110) vertical du conteneur de traitement (100).

6. Conteneur de traitement selon l'une quelconque des revendications 1 à 5, **caractérisé en ce qu'**un des passages de milieu (118) débouche dans l'espace intérieur (112) du conteneur de traitement (100) au niveau d'un emplacement situé plus bas de l'espace intérieur (112) du conteneur de traitement (100).

7. Conteneur de traitement selon l'une quelconque des revendications 1 à 6, **caractérisé en ce que** la partie supérieure de conteneur (104) est reliée, au moyen d'un ensemble d'étanchéité (144) sans espace mort, à une partie inférieure de conteneur (102) du conteneur de traitement (100).

8. Conteneur de traitement selon l'une quelconque des revendications 1 à 7, **caractérisé en ce que** la paroi (124) du conteneur de traitement (100) présente au moins au niveau de son côté intérieur au moins par endroits une rugosité de surface inférieure environ à 0,8 µm.

9. Conteneur de traitement selon l'une quelconque des revendications 1 à 8, **caractérisé en ce qu'**au moins un des passages de milieu (128) peut être fermé au moyen d'un couvercle de fermeture (324) adapté à un adaptateur (134) du passage de milieu (128).

10. Conteneur de traitement selon l'une quelconque des revendications 1 à 9, **caractérisé en ce que** le conteneur de traitement (100) comprend un élément de réception (182), par l'intermédiaire duquel le conteneur de traitement (100) peut prendre appui au niveau d'un support (184) externe.

11. Conteneur de traitement selon la revendication 10, caracté-risé en ce qu'au moins un des passages de milieu (128) présente un adaptateur (132) disposé en dehors de l'espace intérieur (112) du conteneur de traitement (100) servant à adapter l'élément de réception (182) au passage de milieu (128).

12. Combinaison composée au moins d'un conteneur de traite-ment (100) selon l'une quelconque des revendications 1 à 11 et d'au moins deux éléments de traitement de type différent, qui peuvent être adaptés au choix au même passage de milieu (118, 128) du conteneur de traitement (100).

13. Combinaison composée d'au moins deux conteneurs de trai-tement (100) selon l'une quelconque des revendications 1 à 11 et d'au moins un élément de traitement, qui peut être adapté au choix à un passage de milieu (118, 128) d'un premier conteneur de traitement (100) ou à un passage de milieu (118, 128) d'un deuxième conteneur de traitement (100).

14. Combinaison selon l'une quelconque des revendications 12 ou 13, **caractérisée en ce que** la combinaison comprend en outre au moins un appareil de manipulation (192) servant à introduire une pièce à usiner (196) à usiner dans l'espace intérieur (112) au moins d'un des conteneurs de traitement (100).

15. Combinaison selon l'une quelconque des revendications 12 à 14, **caractérisée en ce que** la combinaison comprend en tant qu'élément de traitement une unité de nettoyage par injec-tion, une unité de lavage par submersion et injection, une unité de nettoyage par ultrasons, une unité d'ébavurage haute pression, une unité d'ébavurage à brosse, une unité de séchage par soufflage, une unité de nettoyage à vapeur, une unité d'aspiration, une unité d'aération, un logement pour pièce à usiner, une unité de déplacement de pièce à usiner et/ou une unité de génération de rideau liquide.
